# EUROPÄISCHE PATENTSCHRIFT

(11) **EP 2 135 299 B1**
(45) Veröffentlichungstag und Bekanntmachung des Hinweises auf die Patenterteilung: **25.09.2013**
(21) Anmeldenummer: 08716365.5
(22) Anmeldetag: 07.03.2008
(51) Int. Cl.: H01L 31/05, H01L 31/048, H01L 27/142, H01L 31/068, H01L 31/052

(54) **Frontseitig serienverschaltetes Solarmodul**
Solar module serially connected in the front
Module solaire commuté en série en face avant

(30) Priorität: 08.03.2007 DE 102007011403
(43) Veröffentlichungstag der Anmeldung: 23.12.2009
(73) Patentinhaber: Fraunhofer-Gesellschaft zur Förderung der angewandten Forschung e.V., 80686 München (DE)
(72) Erfinder: LÖCKENHOFF, Rüdiger, 71634 Ludwigsburg (DE)
(74) Vertreter: Weishäupl, Michael
(86) Internationale Anmeldenummer: PCT/EP2008/001851
(87) Internationale Veröffentlichungsnummer: WO 2008/107205

(56) Entgegenhaltungen:
- WO-A-2006/053518
- JP-A- 11 112 008
- JP-A- 55 056 670
- JP-A- 58 196 061
- US-A1- 2005 199 279
- US-B1- 6 278 054
- US-B1- 6 452 086
- US-B1- 6 635 507

## Beschreibung

Die vorliegende Erfindung bezieht sich auf ein Solarzellenmodul, welches frontseitig serienverschaltete Solarzellenelemente umfasst. Die Erfindung bezieht sich darüberhinaus auf Herstellungsverfahren für entsprechende Solarzellenmodule sowie auf Verwendungen entsprechender Solarzellenmodule in Konzentratoreinrichtungen.

Die vorliegende Erfindung findet Anwendung vor allem im Bereich der hochkonzentrierenden Photovoltaiksysteme (Konzentratoranordnung). Hierbei konzentriert ein Hohlspiegel Sonnenlicht mit hoher Intensität auf eine relativ kleine Modulfläche. Bei einer gegenüber dem normalen Sonnenlicht hundertfach angehobenen Lichtintensität spricht man hier von einem Lichtkonzentrationsverhältnis von 100 Sonnen. Auf diese Weise lässt sich teure Solarzellenfläche durch verhältnismäßig günstige Spiegelfläche ersetzen. Bei einem Konzentrationsverhältnis von mehreren 100 Sonnen wird auch die Verwendung von Solarzellen aus III-V Halbleitern und Germanium attraktiv, wie sie sonst typischerweise bei Raumfahrtanwendungen Verwendung finden. Derart hohe Konzentrationsverhältnisse bedingen jedoch sehr hohe elektrische Stromdichten. Ein Quadratzentimeter einer hocheffizienten III-V Solarzelle mit drei pn-Übergängen (Tripelzelle) liefert bei 1000 Sonnen typischerweise einen Strom von 14 A. Um die Verluste im Serienwiderstand der Zelle gering zu halten, müssen Zellen von sehr geringer Breite im Bereich von wenigen Millimetern verwendet werden.

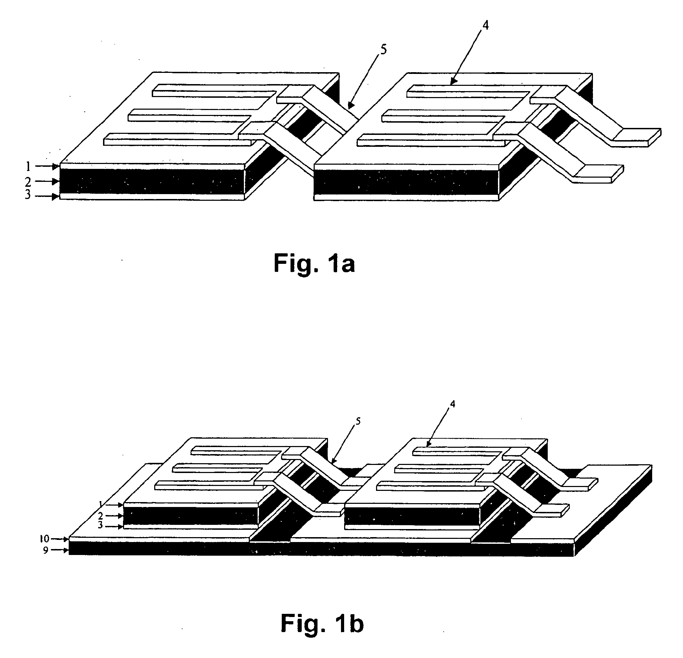

Serienverschaltungen von Solarzellen (die einzelnen Solarzellen werden nachfolgend auch als Solarzellenelemente bezeichnet, mehrere Solarzellenelemente, die zusammengeschaltet sind, ergeben dann ggf. samt ihrer zugehörigen Trägerstruktur ein Solarzellenmodul) sind bereits aus dem Stand der Technik bekannt: Typischerweise wird eine bekannte Serienverschaltung von Solarzellen durch gewinkelte Zellverbinder 5 realisiert, die von der Vorderseite einer Solarzelle auf die Rückseite der jeweils nächsten Zelle in der Reihe führen (Fig. 1a). Diese Verbinder 5 verbinden die Frontseitenmetallisierung 4 der einen Zelle mit der Rückseitenmetallisierung 3 der nächsten Zelle. Auf diese Weise wird die Serienverschaltung einer beliebig langen Reihe von Solarzellen hergestellt. Ein Nachteil dieser Verschaltung ist es, dass die gewinkelten Zellverbinder 5 verhältnismäßig viel Raum einnehmen. Ein Chipabstand bzw. Solarzellenelementabstand von deutlich weniger als 1 mm, wie er für dicht gepackte Konzentratormodule notwendig ist, ist so nicht realisierbar: Dicht gepackte Konzentratormodule sind bzw. eine Schaltung der Zellen zu einem möglichst dicht gepackten Modul ist notwendig, da sonst Licht, das in die Zwischenräume zwischen die Solarzellenchips bzw. Solarzellenelemente fällt, ungenutzt verloren geht.

Die Ausführung nach dem Stand der Technik in Fig. 1 erschwert zudem durch die Zellverbinder 5 auf den Zellrückseiten eine thermische Ankopplung der Solarzellen an eine Kühlfläche 9, wie z.B. ein keramisches Substrat oder einen Kühlkörper. Fig. 1b zeigt eine weitere Möglichkeit zur Kontaktierung nach dem Stand der Technik. Dabei wird ein nicht leitendes Substrat 9 (z.B. Keramik) mit metallisierten Flächen 10 verwendet. Auf diesen Flächen werden die Solarzellen montiert. Die Kontaktierung erfolgt nun von jeder Zelle auf die jeweils nächste Metallfläche durch die Zellverbinder 5. Da hierbei keine rückseitigen Strukturen auf der Zelle notwendig sind, ist eine sehr gute thermische Ankopplung, etwa durch eine dünne Lot- oder Leitkleberschicht möglich. Dabei ist jedoch neben jeder Zelle zur Kontaktierung ein zusätzlicher, verhältnismäßig breiter Streifen notwendig. Hocheffiziente Module sind auf diese Weise aufgrund des relativ hohen Flächenverlusts ebenfalls nicht realisierbar.

Aus der JP 55-056670 A1 ist ein Konzentrator-Solarzellenmodul bekannt, das mehrere aufeinanderfolgende pn-Übergänge aufweist. Dieses Solarzellenmodul weist eine hohe Wärmeleitfähigkeit auf.

Aufgabe der vorliegenden Erfindung ist es somit, Solarzellemodule zur Verfügung zu stellen, welche so aufgebaut oder ausgebildet sind, dass mit ihnen die Lichtverluste in den Zwischenräumen zwischen den einzelnen Solarzellenelementen minimiert werden können, so dass mit ihnen hocheffiziente, hochkonzentrierende Photovoltaiksysteme bzw. Konzentratoranordnungen ermöglicht werden können.

Diese Aufgabe wird durch ein Solarzellenmodul gemäß Patentanspruch 1 sowie zwei Herstellungsverfahren gemäß Patentansprüche 13 und 14 gelöst. Vorteilhafte Weiterbildungen der erfindungsgemäßen Solarzellenmodule sowie des erfindungsgemäßen Herstellungsverfahrens finden sich in den jeweiligen abhängigen Ansprüchen. Verwendungsmöglichkeiten des erfindungsgemäßen Solarzellenmoduls sind in Anspruch 15 angegeben.

Nachfolgend wird die vorliegende Erfindung anhand einzelner Ausführungsbeispiele beschrieben. Einzelne erfindungsgemäße Merkmale, wie sie in den beispielhaften Ausführungsbeispielen in einer bestimmten Kombination gezeigt sind, können jedoch nicht nur in den gezeigten Kombinationen auftreten, sondern im Rahmen der vorliegenden Erfindung auch in beliebigen anderen Kombinationen ausgebildet sein bzw. miteinander verknüpft und verwendet werden.

Die vorliegende Erfindung basiert darauf, die Serienverschaltung der einzelnen Solarzellenelemente ausschließlich vorderseitig bzw. auf der Frontseite der einzelnen Solarzellenelemente vorzunehmen. Eine Parallelverschaltung mehrerer serienverschalteter Solarzellenstränge kann vorderseitig oder rückseitig erfolgen. Hierzu werden die einzelnen Solarzellenelemente wie nachfolgend noch ausführlich beschrieben, geeignet ausgebildet bzw. aufgebaut. Die einzelnen Solarzellenelemente können aufgrund dieses Aufbaus ausschließlich vorderseitig mit geeignet ausgeführten Zellverbindern zu einer Serien- bzw. Parallelverschaltung zusammengeschaltet werden.

Im Folgenden werden einige vorteilhafte, jedoch nicht notwendige, Ausgestaltungen der Erfindung beschrieben, die einzeln oder in Kombination verwirklicht sein können:
In dem erfindungsgemäßen Solarzellenmodul kann die Kühlplatte (9) als strukturtragender Teil, oder als strukturtragender Teil aus Keramik eines aktiven Wasserkühlkörpers ausgebildet sein.

Die Trägerstruktur kann eine zwischen der Kühlplatte (9) und der Rückseitenmetallisierung (3) angeordnete elektrisch nicht leitende Schicht (11), eine Klebstoffschicht oder eine Keramikschicht, aufweisen oder die Trägerstruktur kann eine zwischen der Kühlplatte (9) und der Rückseitenmetallisierung (3) angeordnete elektrische Leiterstruktur aufweisen.

Das erfindungsgemäße Solarzellenmodul kann dadurch gekennzeichnet sein, dass die elektrische Leiterstruktur rückseitenmetallisierungsseitig eine Leitklebstoff- und/oder Lotschicht (11) und kühlplattenseitig eine Leiterbahnstruktur (10) aufweist.

Es kann weiter einen die beiden frontseitenverbundenen Solarzellenelemente (8a, 8b) jeweils auf ihrer Frontseite kontaktierenden Zellverbinder (7) als elektrische Kontaktierung aufweisen.

Der Zellverbinder (7) kann als Draht ausgeführt sein.

Der Zellverbinder (7) kann die erste Frontseitenmetallisierung (4) des ersten der frontseitenverbundenen Solarzellenelemente mit der zweiten Frontseitenmetallisierung (6) des zweiten der frontseitenverbundenen Solarzellenelemente elektrisch verbinden.

Das Solarzellenmodul gemäß der Erfindung kann einen Gold, Silber und/oder Aluminium enthaltenden oder daraus bestehenden Draht als Zellverbinder (7) aufweisen.

Die elektrische Verschaltung kann über Zellverbinder (7, B7) ausgebildet sein.

Die tragende Halbleiterschicht kann bevorzugt eine Dicke von weniger als 200 µm aufweisen.

Das erfindungsgemäße Solarzellenmodul kann eine Germaniumschicht, eine p-dotierte Germaniumschicht, eine Galliumarsenid-Schicht oder eine Siliziumschicht als tragende Halbleiterschicht (2) aufweisen.

Die Halbleiterstruktur aufweisend die tragende Halbleiterschicht (2) und die Schichtstruktur (1) kann monokristallin sein und mindestens zwei photoelektrische aktive pn-Übergänge verschiedener Bandlücke aufweisen.

Die erste (4) und/oder die zweite (6) Frontseitenmetallisierung kann eine einlegierte Metallschichtstruktur aufweisen und/oder die erste (4) und/oder die zweite (6) Frontseitenmetallisierung kann in Form eines zusammenhängenden Schichtgebildes oder in Form mehrerer nicht zusammenhängender Inseln ausgebildet sein.

Die zweite Frontseitenmetallisierung (6) kann genau eine zusammenhängende Metallisierungsfläche aufweisen oder die zweite Frontseitenmetallisierung (6) kann mindestens zwei beabstandet voneinander angeordnete zusammenhängende Metallisierungsflächen (6a, 6b) aufweisen.

Im erfindungsgemäßen Solarzellenmodul kann die erste Dotierung vorzugsweise eine p-Dotierung oder eine n-Dotierung sein.

Das erfindungsgemäße Solarzellenmodul kann eine Parallelschaltung von mindestens zwei Serienschaltungen von Solarzellenelementen aufweisen, wobei jede dieser Serienschaltungen von Solarzellenelementen mindestens zwei in Serie geschaltete, gemäß einem der vorhergehenden Solarzellenmodulansprüche frontseitenverbundene Solarzellenelemente aufweisen kann.

Es kann auch jedes Solarzellenelement einer Serienschaltung mit einem Solarzellenelement mindestens einer anderen Serienschaltung parallel verschaltet sein (paarweise Parallelverschaltung der serienverschalteten Solarzellenstränge).

In der Schichtebene gesehen können mindestens zwei der Solarzellenelemente eine unterschiedliche Gesamtfläche und/oder eine unterschiedliche Fläche ihrer Schichtstruktur (1) aufweisen.

Das erfindungsgemäße Solarzellenmodul kann eine frontseitig angeordnete Verkapselung oder eine mit einer transparenten Vergussmasse als Verkapselung aufgebrachte transparente Platte aufweisen.

Die Vergussmasse kann Silikon sein und/oder die Platte kann eine Glasplatte sein.

Bei der Herstellung des erfindungsgemäßen Solarzellenmoduls kann das Auseinzeln mit Hilfe einer Säge, einer Chipsäge, mittels nass- oder trockenchemischem Ätzen und/oder mittels Laserschneiden durchgeführt werden.

Gegenüber den aus dem Stand der Technik bekannten Solarzellenelementen bzw. Solarzellenmodulen vereinen erfindungsgemäße Solarzellenmodule die Vorteile einer flachen, metallischen Rückseite (welche die Montage vereinfacht) mit der Möglichkeit, die Solarzellen dicht gepackt zu einem Solarzellenmodul zusammenzuschalten. Wie nachfolgend noch näher gezeigt, lassen sich erfindungsgemäß einzelne Solarzellenelemente mit extrem geringem Abstand im Solarzellenmodul realisieren.

Die vorliegende Erfindung wird nun anhand einer Reihe von Ausführungsbeispielen beschrieben. In den einzelnen Ausführungsbeispielen weisen identische bzw. sich entsprechende Bauelemente bzw. Bestandteile der Solarzellenelemente bzw. Solarzellenmodule identische Bezugszeichen auf. Ihre jeweilige Beschreibung wird daher nur anhand eines einzelnen Ausführungsbeispiels (bei ihrem ersten Auftreten) vorgenommen und nicht wiederholt.

In den Figuren zu den Ausführungsbeispielen werden die folgenden Bezugszeichen verwendet:
- 1, 1a, 1c:: Elektrisch aktive Halbleiterschichten veränderlicher Dotierung
- 2:: Tragende Halbleiterschicht (auch Halbleitersubstratschicht oder Substratschicht genannt) mit genau einem Dotierungstyp (n-oder p-Typ) bzw. Wafer
- 3:: Rückseitenmetallisierung der Solarzelle bzw. Bypassdiode
- 4:: Frontseitenmetallisierung der Solarzelle
- 4a:: Frontseitenmetallisierung von 13
- 4b:: Frontseitenmetallisierung von 14
- 4c:: Frontseitenmetallisierung von 15
- 5:: Gewinkelter Zellverbinder zur Kontaktierung von Zellvorder- und Rückseiten nach dem Stand der Technik.
- 6, 6a, 6b, S6:: Frontseitige Metallisierung auf dem Substrat 2 eines Solarzellenelements in einer Lücke der elektrisch aktiven Schicht 1 bzw. 1a, 1c.
- B6:: wie 6, nur bei Bypassdiode
- 7, 7a, 7b:: Frontseitiger Zellverbinder zwischen zwei Solarzellenelementen
- B7:: Frontseitige Zellverbinder zwischen zwei Bypassdioden
- SB7:: Frontseitige Zellverbinder zwischen einem Solarzellenelement und einer Bypassdiode
- 8, 8a, 8b:: Solarzelle bestehend aus den Kennziffern 1,2,3,4 und 6 und ggf. weiteren Elementen wie Isolations- oder Antireflexschichten nach dem Stand der Technik.
- 9:: Kühlfläche, z.B. ein keramisches Substrat oder eine Kühlplatte oder ein Kühlkörper
- 10:: Metallische Leiterbahnstruktur auf der Kühlfläche 9
- 11:: Lotschicht oder thermisch leitfähige Klebstoffschicht
- 12:: Metallische Busse, die auf das keramische Substrat 9 aufgebracht sind
- 13:: Einzelne Bypassdiode, 13a: Einzelne Bypass-diode mit gegenüber 13 umgekehrter Polung
- 14:: Bypassdiode, die auf einer gemeinsamen tragenden Halbleiterschicht 2 mit einer Solarzelle 8 platziert ist
- 15:: Bypassdiode zur frontseitigen Kontaktierung
- 16:: p-dotiertes Germanium Substrat, Basis der Germaniumzelle
- 17:: Durch Diffusion n-dotiertes Germanium, Emitter der Germaniumzelle
- 18:: Tunneldiode zwischen der Germanium und GaAs Zelle
- 19:: MOVPE abgeschiedenes p-dotiertes Galliumarsenid (p-Typ GaAs), Basis der GaAs Zelle und Bypassdiode
- 20:: MOVPE n-Typ GaAs, Emitter der GaAs Zelle und der Bypassdiode
- 21:: Tunneldiode zwischen der GaAs und GaInP Zelle
- 22:: MOVPE abgeschiedenes p-dotiertes Gallium-Indium-Phosphid (n-Typ GaInP), Basis der GaInP Zelle
- 23:: MOVPE n-Typ GaInP, Emitter der GaInP Zelle
- 24:: MOVPE abgeschiedenes GaAs, Deckschicht für niederohmige Metall-Halbleiterkontakte
- 25:: Palladium (Pd) Schicht der Metallisierung
- 26:: Germanium (Ge) Schicht der Metallisierung
- 27:: Hochleitfähige Metallisierungsschicht, z.B. galvanisches Gold oder vakuum-aufgedampftes Silber
- 28:: Transparente Frontscheibe
- 29:: Transparente Vergussmasse
- 30:: Spalte zur Vereinzelung der Solarzellenelemente

Es zeigt:
- Figur 1: eine Serienverschaltung von zwei Solarzellenelementen nach dem Stand der Technik.
- Figur 2: eine Serienverschaltung von Solarzellenelementen nach der vorliegenden Erfindung.
- Figur 3: die Realisierung der Serienverschaltung nach Figur 2 auf einer Trägerstruktur.
- Figur 4: eine weitere Realisierungsmöglichkeit der in Figur 2 gezeigten Anordnung auf einer Trägerstruktur.
- Figur 5: die Kombination einer erfindungsgemäßen Anordnung nach Figur 2 mit einer Trägerstruktur und mit Bypassdioden.
- Figur 6: eine weitere Möglichkeit zur Realisierung einer Kombination aus erfindungsgemäßer Anordnung nach Figur 2, aus Bypassdioden und aus einer Trägerstruktur.
- Figur 7: eine weitere solche Kombinationsmöglichkeit, wie sie in ähnlicher Form in Figuren 5 und 6 gezeigt ist.
- Figur 8: eine bevorzugte Realisierung eines Solarzellenelements auf Basis einer Dreifachsolarzelle und eine entsprechende Realisierung einer Bypassdiode.
- Figur 9: eine bevorzugte Montagevariante eines erfindungsgemäßen Solarzellenmoduls.
- Figur 10: eine erreichte Effizienz bei einem nach Figur 2b ausgebildeten Ausführungsbeispiel mit einer ausschließlich vorderseitig kontaktierten Solarzelle.

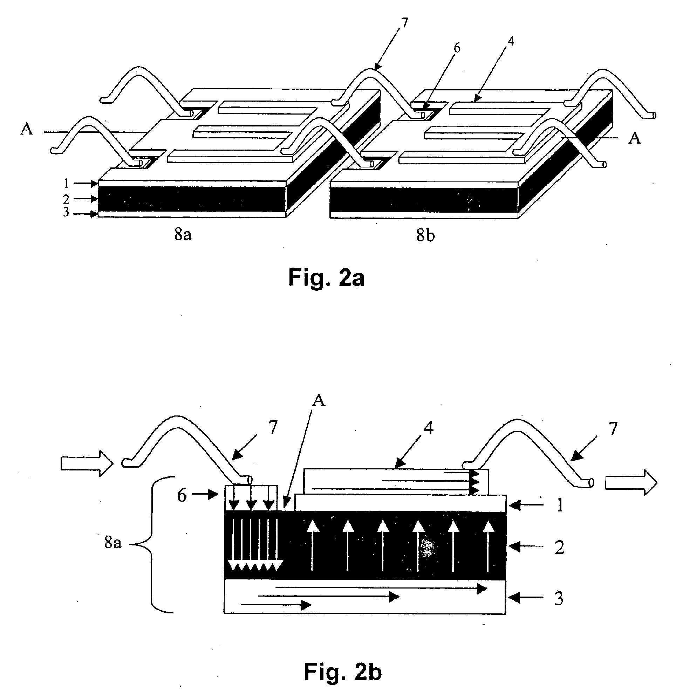

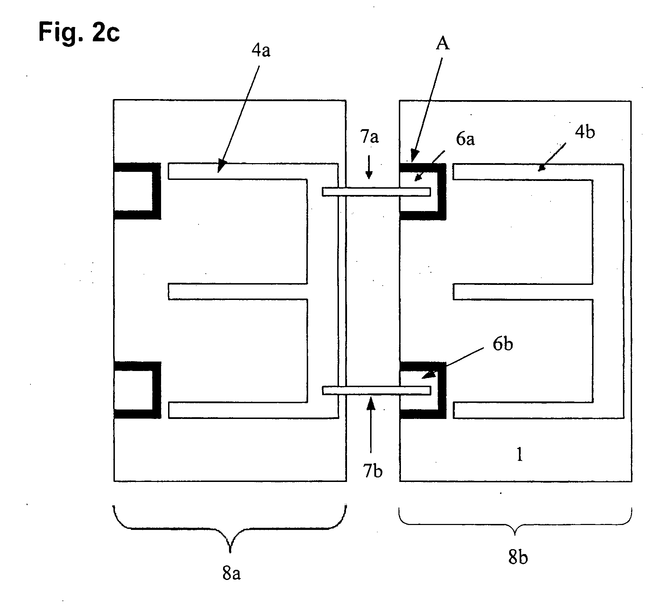

Figur 2 zeigt zwei Solarzellenelemente 8a, 8b sowie eine erfindungsgemäße elektrische Serienverschaltung dieser beiden Solarzellenelemente zu einem erfindungsgemäßen Solarzellenmodul. Figur 2a zeigt dies in einer dreidimensionalen Übersichtsskizze, Figur 2b zeigt eines der Solarzellenelemente (Element 8a) in einer Schnittansicht in der Ebene A-A senkrecht zur Halbleiterschichtebene der Anordnung und senkrecht zu einer Achse, auf der die einzelnen Solarzellenelemente beabstandet voneinander und nebeneinander angeordnet sind (Richtung der elektrischen Hintereinanderschaltung). Figur 2c zeigt eine Aufsicht auf die erfindungsgemäße Anordnung senkrecht zur Halbleiterschichtebene.

Jedes der Solarzellenelemente 8a, 8b besteht aus den folgenden Bauteilen: einer tragenden Halbleiterschicht 2 (nachfolgend alternativ auch Wafer, Halbleitersubstratschicht oder einfach Substratschicht genannt, obwohl es sich hierbei nicht zwangsläufig um eine elektrisch inaktive Schicht handelt), einer auf einer Seite der Halbleitersubstratschicht 2 und angrenzend an diese angeordneten Rückseitenmetallisierung 3 (im Bild die Unterseite der Schicht 2), und einer auf der Oberseite (der rückseitenmetallisierungsabgewandten Seite) angeordneten ersten Frontseitenmetallisierung 4, zweiten Frontseitenmetallisierung 6 sowie Schichtstruktur 1. Bei der tragenden Halbleiterschicht R handelt es sich um den Wafer. Bei Stapelung kann die Schicht 2 die Basis der untersten Solarzelle bilden. Die Metallisierung 3 kann eine flächige, insbesondere eine ganzflächige, nicht strukturierte Metallisierung sein (in den nachfolgenden Beispielen meist der Fall), es kann sich aber auch um eine nicht die ganze Oberfläche abdeckende (nicht zusammenhängende), strukturierte Metallisierung handeln. Die Schichtstruktur 1 ist auf der Oberseite der Substratschicht 2 angrenzend an diese so angeordnet, dass nicht die gesamte Oberfläche der Substratschicht 2 von der Schichtstruktur 1 bedeckt wird. Die Oberseite (Frontseite) der Substratschicht 2 weist somit eine Aussparung A auf, die nicht mit der Schichtstruktur 1 bedeckt ist. Innerhalb dieser Aussparung A ist die zweite Frontseitenmetallisierung 6 des Solarzellenelements unmittelbar angrenzend an die Substratschicht 2 und auf dieser seitlich beabstandet von der Schichtstruktur 1 angeordnet. Aufgrund des seitlichen Abstands zwischen der Schichtstruktur 1 und der zweiten Frontseitenmetallisierung 6 sind diese beiden Elemente 1, 6 somit elektrisch voneinander isoliert. Auf der Schichtstruktur 1 und angrenzend an diese ist die erste Frontseitenmetallisierung 4 des Solarzellenelements angeordnet. Diese Struktur 4 ist hier so angeordnet, dass die Schichtstruktur 1 teilweise bedeckt wird, jedoch keine seitlichen Überstände der ersten Frontseitenmetallisierung 4 über die Schichtstruktur 1 realisiert sind.

Wie insbesondere die Aufsicht in Figur 2c zeigt, ist die zweite Frontseitenmetallisierung 6 hier mittels zweier getrennter, beabstandet voneinander auf der Substratschicht bzw. dem Wafer 2 angeordneter Einzelelemente 6a und 6b ausgebildet. Diese sind stirnseitig angrenzend an eine Seitenfläche der Solarzellenelemente 8a, 8b so angeordnet, dass sie in Bezug auf die frontseitige Oberfläche der Elemente 8a, 8b gesehen von der Schichtstruktur 1 vollständig umgeben werden (es entsteht somit eine E-förmige Ausbildung der Schichtstruktur 1, welche die gesamte Oberfläche der Substratschicht 2 bis auf die von der zweiten Frontseitenmetallisierung 6a, 6b bedeckten Oberflächenabschnitte sowie zwei schmale Gräben zwischen den Elementen 1 und 6a, 6b vollständig bedeckt). Auf der Schichtstruktur 1 und in Schichtebene gesehen seitlich nicht überstehend über diese, somit ebenfalls beabstandet und elektrisch isoliert von der zweiten Frontseitenmetallisierung 6 ist hier die erste Frontseitenmetallisierung 4 des Elements 8 kammförmig aufgebracht.

Die erste Frontseitenmetallisierung 4 und die zweite Frontseitenmetallisierung 6 sind diejenigen elektrischen Kontakte des Solarzellenelements, welche im Normalbetrieb in einem Solarzellenmodul den Hauptteil des elektrischen Stroms transportieren.

Die erste Frontseitenmetallisierung 4 ist hier in Form eines zusammenhängenden Gebiets (Kammform) aufgebracht, die zweite Frontseitenmetallisierung 6 in Form mehrerer, hier zwei, voneinander getrennter, in sich dann wieder jeweils zusammenhängender (hier quaderförmiger) Inseln. Es ist jedoch ebenso gut möglich, die erste Frontseitenmetallisierung in Form mehrerer solcher getrennter Inseln auszugestalten und die zweite Frontseitenmetallisierung 6 in Form eines zusammenhängenden Schichtgebildes. Ebenso ist es natürlich möglich, sowohl die erste, als auch die zweite Frontseitenmetallisierung jeweils in Form mehrerer nicht-zusammenhängender Inseln auszugestalten oder beide Frontseitenmetallisierungen in Form von jeweils einzelnen, zusammenhängenden Schichtgebilden auszugestalten.

Durch die gezeigte Anordnung der Schichtstruktur 1 und der zweiten Frontseitenmetallisierung 6 (in Form der beiden Elemente 6a und 6b) auf der Oberfläche der Substratschicht 2 eines Solarzellenelements wird somit der Vorteil realisiert, dass der Verlust an aktiver Solarzellenfläche minimiert werden kann.

Wie die Figuren 2a, 2b und 2c zeigen, ist die erste Frontseitenmetallisierung 4a des linkseitig gezeigten Solarzellenelements 8a über zwei elektrisch leitfähige Zellverbinder 7a und 7b mit der zweiten Frontseitenmetallisierung 6 des rechts gezeigten Solarzellenelements 8b verbunden. Der Zellverbinder 7a verbindet hierbei die erste Frontseitenmetallisierung 4a der linken Solarzelle mit dem Element 6a der zweiten Frontseitenmetallisierung der rechten Solarzelle, der zweite Zellverbinder 7b verbindet das Element 4a entsprechend mit dem Frontseitenelement 6b. Die beiden Zellverbinder 7a, 7b sind hierbei als ultraschallgeschweißte Golddrähte ausgestaltet.

Auf der den Elementen 1, 4 und 6 gegenüberliegenden Rückseite erstreckt sich jeweils die Rückseitenmetallisierung 3 der Solarzellenelemente 8a, 8b vom Bereich der zweiten Frontseitenmetallisierung 6 des Elements 8a, 8b bis in den Bereich der ersten Front-seitenmetallisierung 4 des Elements. Projizierte man die Elemente 1, 4 und 6 daher senkrecht zur Schichtebene auf die Rückseitenmetallisierung 3, so würde diese Rückseitenmetallisierung die projizierten Elemente 1, 4 und 6 vollständig umfassen.

Gezeigt ist somit eine niederohmige, ausschließlich vorderseitige Serienverschaltung der Solarzellen 8a, 8b. Die Solarzellen bestehen aus der tragenden Halbleiterschicht 2 mit einem ersten Dotierungstyp (p- oder n-Typ) und der Schicht oder Schichtstruktur 1 mit veränderlicher Dotierung, die mindestens eine zu 2 abweichende Dotierung hat. Im Allgemeinen ist die Schicht 2 jener Teil der Halbleiterscheibe, der als Basis der (untersten) Solarzelle dient. Die Schicht 1 wird durch den Emitter der (untersten) Solarzelle und ggf. weitere Solarzellenübergänge und Schichten gebildet. Die Schicht 1 ist mit der Frontseitenmetallisierung 4 versehen, die zur Halbleiterschicht einen niedrigen ohmschen Kontaktwiderstand hat. Ebenso ist die Schicht 2 mit der Rückseitenmetallisierung 3 mit niedrigem Kontaktwiderstand versehen. Darüber hinaus ist die Halbleiterschicht 1 auf der Zellvorderseite im Bereich A stellenweise entfernt. An diesen Stellen sind die Metallisierungen 6 mit niedrigem Kontaktwiderstand frontseitig auf die Halbleiterschicht 2 aufgebracht. Die Metallisierungen 6 und 4 können in einem gemeinsamen oder auch in getrennten Metallisierungsschritten aufgebracht werden. Die Serienverschaltung in einer Reihe von Solarzellen erfolgt nun jeweils von der Frontseitenmetallisierung 4 einer Zelle zu den Metallisierungen 6 der nächsten Zelle. Abbildung 2b zeigt einen Querschnitt durch die Zelle samt Zellverbinder. Der Stromweg ist hier durch Pfeile symbolisiert (ohne Beschränkung auf eine Polarität). Der Strom tritt aus dem Zellverbinder 7 durch die Metallisierung 6 in die unmittelbar an diese Metallisierung angrenzende, tragende Halbleiterschicht 2 ein. Er durchströmt die tragende Halbleiterschicht 2 (Wafer) mit hoher Stromdichte und gelangt in die unmittelbar an den Wafer 2 angrenzende, gut elektrisch leitfähige Rückseitenmetallisierung. Dort wird der Strom über die Zellrückseite verteilt. Wesentlich ist, dass sich zwischen der Metallisierung 6 und der Rückseitenmetallisierung 3 ausschließlich die Waferschicht 2 befindet. Die eigentliche.Generation elektrischer Leistung erfolgt in der Halbleiterschicht (-struktur) 1, wobei die tragende Halbleiterschicht 2 als "Basis" der (untersten) Solarzelle wirken kann. Der Strom durchfließt dabei über die aktive Solarzellenfläche 1 verteilt einen oder mehrere pn-Übergänge, bis er schließlich in die Frontseitenmetallisierung 4 gelangt. Von dort fließt er durch einen weiteren Zellverbinder 7 zur nächsten Zelle. Zur leichteren Bezugnahme wird die Solarzelle bestehend aus den Kennziffern 1, 2, 3, 4 und 6 sowie weiteren Elementen wie beispielsweise einer Isolations- und/oder Antireflexschicht mit der Kennziffer 8 bezeichnet. In den folgenden Figuren werden jeweils nur zwei Solarzellen gezeigt. Es versteht sich aber, dass sich größere Solarmodule auf gleiche Weise durch eine entsprechende Serienverschaltung beliebig vieler Solarzellen erreichen lassen. Ebenso kann eine Parallelschaltung beliebig vieler Solarzellen oder serienverschalteter Solarzellenstränge erfolgen.

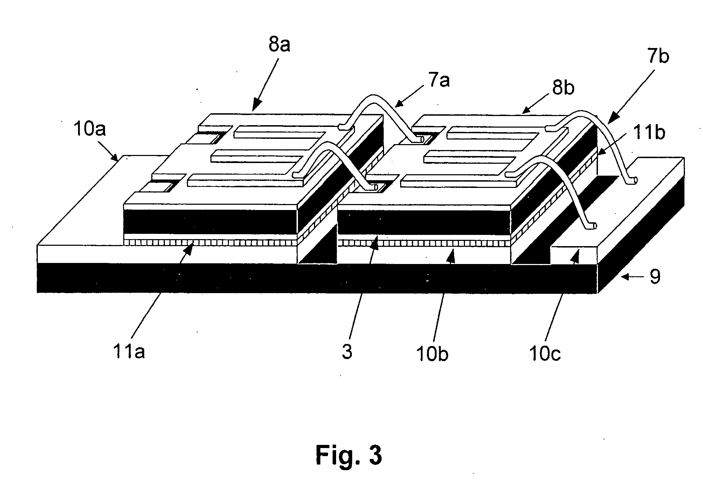

Figur 3 zeigt ein weiteres Ausführungsbeispiel, bei dem die erfindungsgemäße Solarzellenanordnung (Solarzellenelemente 8a und 8b) der Figur 2 auf einer Trägerstruktur 9, 10, 11 angeordnet ist. Das Element 9 ist eine Kühlplatte mit elektrisch nicht leitender Frontseite (z.B. ein aktiver Wasserkühlkörper mit keramischer Front oder eine keramische Platte, die im Allgemeinen ihrerseits auf einem aktiven Kühlkörper montiert ist). Die Kühlplatte oder der Verbund aus Platte und aktivem Kühlkörper wird nachfolgend alternativ vereinfachend auch als "Kühlkörper" bezeichnet. Diese Trägerstruktur weist desweiteren auf zwei elektrisch voneinander isolierte, auf der Oberseite der Kühlplatte bzw. des Kühlkörpers 9 angeordnete elektrische Leiterbahnstrukturen 10a und 10b sowie auf der Oberseite (kühlkörperabgewandten Seite) der Leiterbahnstrukturen 10a und 10b jeweils angeordnete Lotschichten 11a und 11b (alternativ kann es sich auch um eine Schicht aus elektrisch und thermisch leitfähigem Klebstoff handeln). Auf der Lotschicht 11a ist das Solarzellenelement 8a angeordnet, auf der Lotschicht 11b das Solarzellenelement 8b. Die in Fig. 3 gezeigte Serienverschaltung ist (Positionierung der Solarzellen auf gemeinsamen Leiterbahnen) zur paarweisen Parallelverschaltung von mehreren serienverschalteten Solarzellensträngen geeignet. Diese Verschaltung erlaubt einen Ausgleich der Stromgeneration bei den parallel verschalteten Solarzellen und damit geringere Verluste bei inhomogener Beleuchtung.

Die gezeigte erfindungsgemäße Anordnung vereint die Vorteile einer flachen, metallischen Solarzellenrückseite, welche die Montage vereinfacht, mit der Möglichkeit, die Solarzellen 8 dicht gepackt zu einem Modul zu verschalten. Hierbei sind die Solarzellen mit Leitklebstoff oder Lotschichten 11 auf einer Leiterbahnstruktur 10 montiert, die sich wiederum auf der Kühlfläche 9 befindet. Die Verschaltung der Zellen untereinander erfolgt vorderseitig durch Zellverbinder 7a. Die Rückseite der ersten Zelle links im Bild wird direkt über eine Leiterbahn der Leiterbahnstruktur 10 kontaktiert und bildet einen Pol der Serienverschaltung. Hingegen verbinden Zellverbinder 7b die Frontmetallisierung der letzten Zelle, rechts im Bild mit einer separaten, seitlich beabstandet von dem Block 10b, 11b, 8b auf dem Kühler 9 angeordneten Leiterbahn 10c der Leiterbahnstruktur 10, welche den anderen Pol der Serienverschaltung bildet. Die auf diese Weise realisierte Serienverschaltung kann auf beliebig viele in Reihe verschaltete Zellen ausgedehnt werden. Ebenso ist es möglich, mehrere dieser serienverschalteten Reihen parallel anzuordnen.

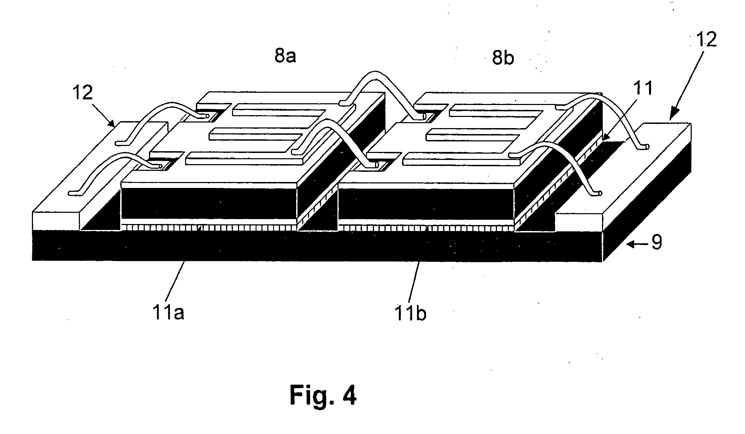

Figur 4 zeigt eine weitere erfindungsgemäße Anordnung eines erfindungsgemäßen Solarzellenmoduls nach Figur 2 auf einer eine Kühlstruktur 9 aufweisenden Trägerstruktur 9, 11. Der Kühlkörper 9 ist hier ebenfalls als nicht-leitender Kühlkörper mit keramischer Front ausgebildet (z.B. als Keramikfrontplatte, welche ein strukturtragender Teil eines Wasserkühlkörpers z.B. der Firma Curamik ist), kann aber auch alternativ als metallischer Kühlkörper realisiert sein. Auf der Oberfläche des Kühlkörpers mit keramischer Front ist unterhalb der beiden Solarzellenelemente 8a, 8b jeweils eine elektrisch nicht-leitfähige Schicht 11 aus Kleber bzw. aus einem Isolator (z.B. Keramik) angeordnet. Zusätzlich kann die Schicht 11 ein Dielektrikum wie Polyimid oder SiOₓ umfassen. Auf den hier separat und beabstandet voneinander ausgebildeten Schichtabschnitten 11a und 11b ist dann jeweils die Rückseitenmetallisierung 3 der beiden Elemente 8a, 8b angeordnet. Bei der Realisierung in Fig. 4 entfällt die Leiterbahnstruktur 10, diese ist somit zur Serienverschaltung der Solarzellen nicht unbedingt erforderlich. Stattdessen werden lediglich seitliche stromzuführende Busse 12 benötigt. Die Funktion der Serienverschaltung bleibt davon unbeeinträchtigt. In Verbindung mit einer elektrisch nicht leitfähigen Klebstoffschicht 11 oder einer zusätzlichen Isolatorschicht kann als Kühlfläche 8 sogar ein metallischer Kühlkörper verwendet werden, ohne dass dies den Kurzschluss der Serienverschaltung zur Folge hätte. Selbstverständlich dürfen dazu die Busse 12 nicht im elektrischen Kontakt mit dem Kühlkörper stehen. Wird wie hier eine keramische Frontplatte 9 ohne Leiterbahnstruktur 10 verwendet, so kann zur Montage ein nur thermisch leitfähiger Klebstoff verwendet werden, um Kurzschlüsse durch überquellenden Klebstoff zu vermeiden.

In einer Serienverschaltung von Solarzellen unterscheiden sich die Kurzschlussströme der Einzelzellen. Dies gilt insbesondere dann, wenn das Modul inhomogen beleuchtet wird. Die Verteilung des Lichts im Brennfleck eines Konzentratorsystems wird nie ganz homogen sein. Wird nun ein solches Solarmodul im Kurzschluss betrieben, wird es in der Regel eine Solarzelle geben, die den Strom des Gesamtmoduls begrenzt. An dieser Solarzelle fällt eine hohe Spannung in Sperrrichtung ab, die von den anderen Solarzellen im Modul generiert wird. Bei einer ausreichend hohen Sperrspannung wird diese Zelle zerstört und eine andere Zelle wird strombegrenzend. Deshalb ist es notwendig die Solarzellen durch Bypassdioden zu schützen, die parallel jedoch mit umgekehrter Polarität zu den Zellen verschaltet werden. Im Folgenden wird erläutert, wie erfindungsgemäß ein Schutz der Solarzellen durch Bypassdioden realisierbar ist.

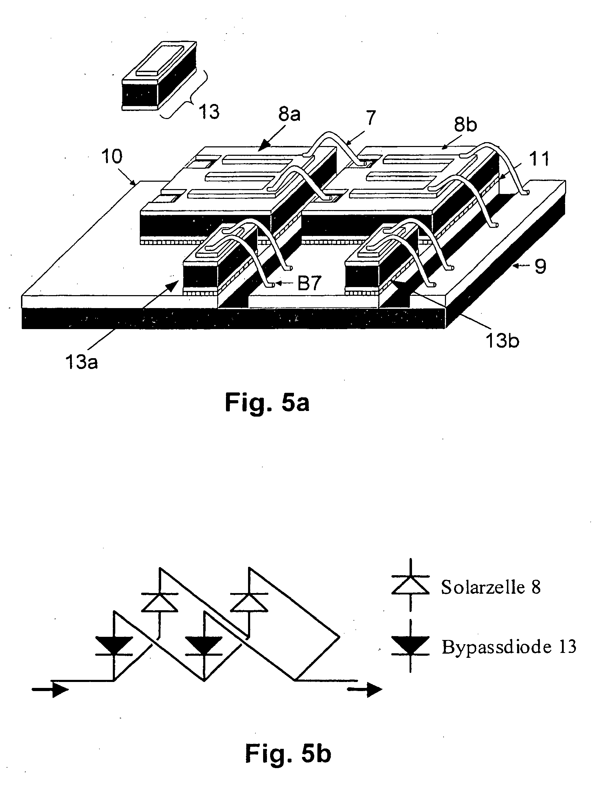

Figur 5 zeigt eine weitere Ausführungsform der vorliegenden Erfindung, bei der zwei seriell verschaltete Solarzellenelemente 8a, 8b jeweils eine Bypassdiode (z.B. Schottky Diode), welche parallel zum jeweiligen Solarzellenelement, jedoch mit umgekehrter Polarität geschaltet ist, aufweisen. Die Trägerstruktur 9, 10, 11 ist hier wie bei dem in Figur 3 gezeigten Beispiel ausgebildet. Die Leiterbahnstruktur 10 weist hier jedoch eine größere Grundfläche auf, so dass seitlich neben jedem Solarzellenelement jeweils die zugehörige separate Bypassdiode 13 auf der Leiterbahnstruktur platziert werden kann. In der Figur 5a ist gezeigt, wie die Bypassdioden 13 gemeinsam mit den Solarzellenelementen 8 auf Leiterbahnen der Leiterstruktur 10 platziert sind. Durch die elektrische Verbindung der Rückseitenmetallisierung 3 eines Solarzellenelements mit einer entsprechend ausgeführten Rückseitenmetallisierung der zugehörigen Bypassdiode 13 mit Hilfe der Leiterstruktur 10, durch eine Inreiheschaltung der Solarzellenelemente mit Hilfe der Zellverbinder 7 sowie durch eine entsprechende Inreiheschaltung der separaten Bypassdioden 13a, b mit Hilfe analog ausgeführter Zellverbinder B7 wird erreicht, dass die Solarzellen in Reihe verschaltet sind und zu jeder Solarzelle eine Bypassdiode mit umgekehrter Polarität parallel geschaltet ist (siehe Schaltbild in Figur 5b).

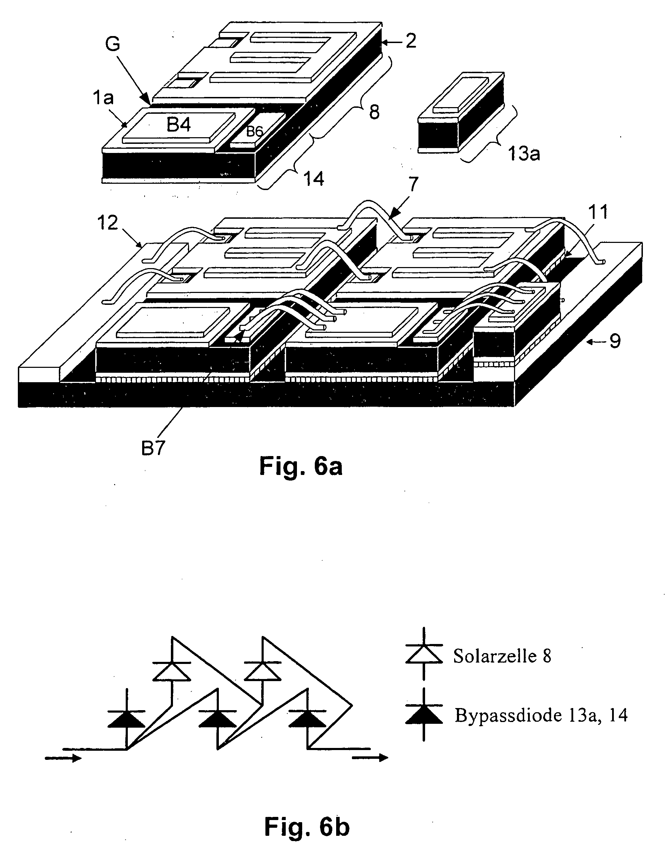

Figur 6 zeigt ein weiteres Ausführungsbeispiel eines erfindungsgemäßen Aufbaus unter der Verwendung von Bypassdioden 13a, 14, wobei hier die Trägerstruktur 9, 10, 11 wieder wie bei dem in Figur 4 gezeigten Beispiel ausgebildet ist. Die Bypassdioden 14 werden hierbei so realisiert, dass die Substratschicht 2 der Solarzellenelemente mit einer vergrößerten Grundfläche zur Verfügung gestellt wird und dass auf der Frontseite ein Teil 1a der elektrisch aktiven Schichtstruktur 1 der Solarzellenelemente abgetrennt wird (Graben G, in dem die Schichtstruktur 1 auf der Frontseite der Substratschicht 2 fehlt; hierdurch Ausbildung zweier separater Bereiche, des Bypassdiodenbereichs 14 und des Solarzellenelementbereichs 8). Auf der Rückseite der Substratschicht 2 ist dann eine gemeinsame Rückseitenmetallisierung 3 für die beiden Bereiche 8 und 14 ausgebildet. Die elektrische Verschaltung der Bypassdiodenelemente 14 und der Solarzellenelemente 8 erfolgt im Prinzip wie in Figur 5 gezeigt (siehe Fig. 6b).

Im Bypassdiodenbereich 14 ist auf der Frontseite der Substratschicht 2 auf dem auf der Substratschicht 2 angeordneten abgetrennten Bereich 1a der elektrisch aktiven Schicht eine erste Frontseitenmetallisierung B4 der Bypassdiode angeordnet. Elektrisch separiert von den Elementen 1a und B4 ist seitlich davon ebenfalls im Bypassdiodenbereich 14 eine zweite Frontseitenmetallisierung B6 der Bypassdiode angeordnet. Die Verschaltung benachbarter Bypassdioden geschieht ganz analog wie bei der Verschaltung benachbarter solar-zellenelemente dadurch, dass die zweite Frontseitenmetallisierung B6 einer Bypassdiode 14 mit der ersten Frontseitenmetallisierung B4 einer benachbarten Bypassdiode mittels Zellverbinder B7 verbunden wird.

Figur 6a baut somit auf der Realisierung in Fig. 4 auf, bei der unter den Solarzellen keine Leiterstruktur 10 vorgesehen ist. Hier werden die Bypassdiode 14 und die Solarzelle 8 auf einem gemeinsamen Chip vereint. Dazu wird ein Teil der elektrisch aktiven Schicht 1 abgetrennt und nun als 1a bezeichnet. Wenn 1 aus mehreren Diodenübergängen besteht, so ist es möglich eine oder mehrere Diodenübergänge von 1a zu entfernen, ohne die Wirkung als Bypassdiode einzuschränken. Zur Kontaktierung werden auf der Bypassdiode 14 Metallisierungen B4 und B6 aufgebracht. Die Kontaktierung erfolgt nun bei den Solarzellen analog zu Fig. 3. Auf ähnliche Weise, jedoch mit umgekehrter Polarität, werden die Bypassdioden 14 verschaltet. Betrachtet man das Ersatzschaltbild Fig. 6b, so fällt auf, dass die Bypassdiode 14 links im Bild ungenutzt bleibt, wohingegen die Solarzelle 8 rechts im Bild nicht durch eine Bypassdiode 14 geschützt ist. Deshalb ist eine weitere einzelne Bypassdiode 13a notwendig, die parallel zur rechten Zelle geschaltet wird.

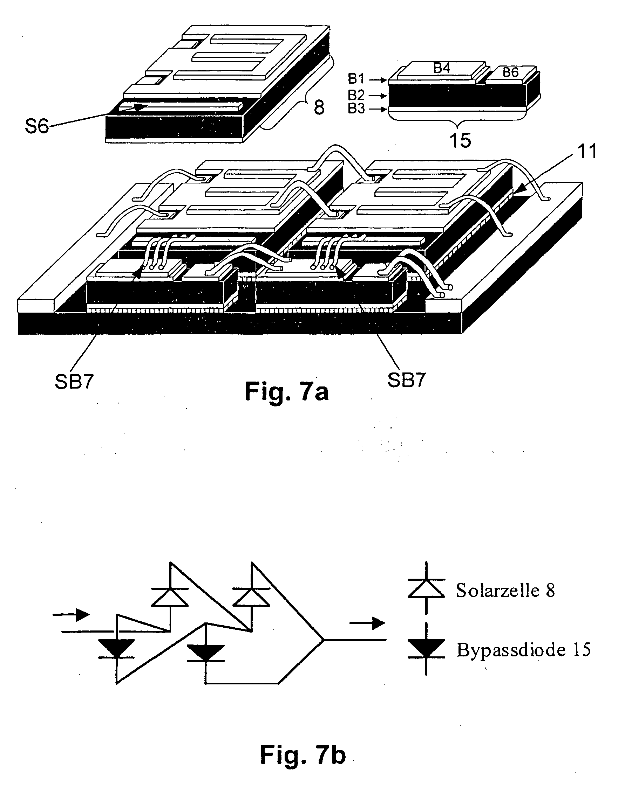

Figur 7 zeigt eine weitere erfindungsgemäße Ausführungsform der Verschaltung von Solarzellenelementen 8 mit Bypassdioden 15. Die Bypassdioden 15 sind hier als separate Bypassdioden ausgebildet, d.h. die Solarzellenelemente 8 und die Bypassdioden 15 weisen keine gemeinsamen Strukturen (wie beispielsweise Substratschichten 2 oder Rückseitenmetallisierungen 3) auf.

Die Trägerstruktur 9, 11 ist hier analog wie in Figur 4 ausgebildet, jedoch ist hier entsprechend zwischen den Rückseitenmetallisierungen 3 der beiden Bypassdi-oden und den Rückseitenmetallisierungen 3 der beiden separat davon angeordneten Solarzellenelemente jeweils eine elektrisch nicht-leitfähige Kleber- bzw. Isolatorschicht 11 angeordnet.

Eine elektrische Verschaltung der Solarzellenelemente und Bypassdioden analog der vorher beschriebenen lässt sich nun wie folgt realisieren (Figur 7a zeigt hierbei, dass auch ohne eine Leiterstruktur 10 unter den Solarzellenelementen 8 eine solche Verschaltung mit externen Bypassdioden 15 möglich ist): Hierzu müssen die separaten Bypassdioden 15 ähnlich den Solarzellen 8 zur Vorderseitenverschaltung geeignet sein. Sie bestehen daher hier aus einer dotierten, tragenden Halbleiterschicht B2, einer auf deren Frontseite angeordneten Schicht entgegengesetzter Dotierung B1, die nur einen Teil des Halbleitersubstrats B2 bedeckt. Auf der unbedeckten Fläche ist elektrisch isoliert von der Schicht B1 eine Metallisierung B6 als Kontakt auf der tragenden Halbleiterschicht B2 aufgebracht. Auch auf der dotierten Schicht B1 ist ein metallischer Kontakt B4 aufgebracht. Die Rückseitenmetallisierung B3 der separaten Bypassdioden 15 ist wie bei den Solarzellenelementen 8 ausgestaltet. Um die vorbeschriebene elektrische Verschaltung zu realisieren, haben die Solarzellenelemente 8 eine zusätzliche seitliche Fläche, auf denen das Halbleitersubstrat 2 nicht mit der Schichtstruktur 1 versehen ist. Auf dieser Fläche ist dann auf der Frontseite auf der Substratschicht 2 elektrisch isoliert von der Schichtstruktur 1 und seitlich beabstandet von dieser ein zusätzlicher metallischer Kontakt S6 aufgebracht. Dieser elektrische Kontakt S6 jedes Solarzellenelements 8 ist über einen analog den Zellverbindern 7, B7 ausgebildeten Zellverbinder SB7 frontseitig mit dem metallischen Kontakt B4 der zugehörigen Bypassdiode verbunden. Wie in Figur 6 gezeigt, wird dann der metallische Kontakt B4 einer Bypassdiode wieder mit dem metallischen Kontakt B6 der benachbarten Bypassdiode mittels Zellverbinder B7 frontseitig verbunden. Die Bypassdioden und die Solarzellen werden somit, wie in Figur 7 zu sehen, jeweils in Serie verschaltet. Zusätzlich wird durch Zellverbinder SB7 ein Parallelkontakt zwischen den Flächen S6 auf den Solarzellen und B4 auf den Bypassdioden hergestellt. Wie aus dem Ersatzschaltbild in Figur 7b ersichtlich ist, ist auf diese Weise jede Solarzelle durch eine parallel geschaltete Bypassdiode mit umgekehrter Polarität geschützt.

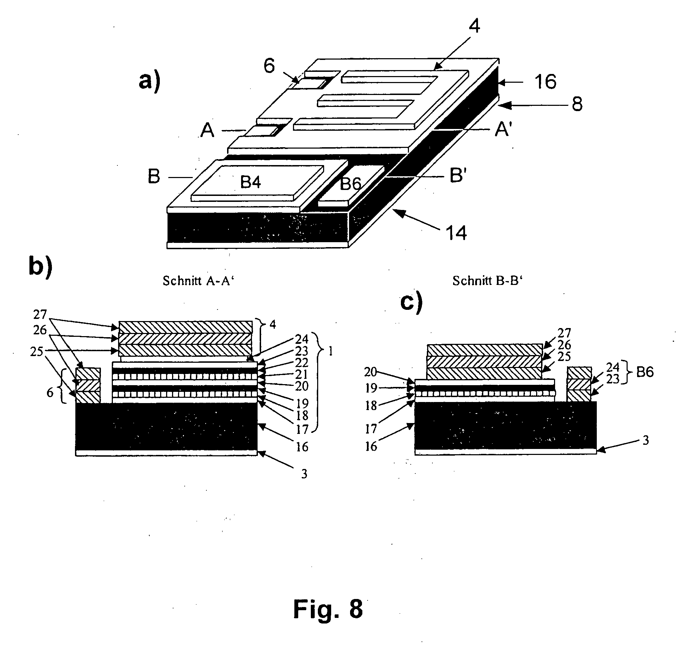

Figur 8 zeigt eine bevorzugte erfindungsgemäße Realisierung eines Solarzellenelements auf Basis einer Dreifachsolarzelle. Figur 8a zeigt hierbei eine dreidimensionale Übersicht, Figur 8b zeigt einen Schnitt durch das Solarzellenelement mit integrierter Bypassdiode auf Höhe des Solarzellenbereichs 8, Figur 8c zeigt entsprechend einen Schnitt auf Höhe des Bypassdiodenbereichs 14 (Schnitte senkrecht zur Schnittebene).

Als tragende Halbleiterschicht 16 (entspricht 2) dient typischerweise eine p-dotierte Germanium Halbleiterscheibe 16 (Germanium Wafer) mit einer Dicke von 150 µm. Um die Durchkontaktierungen zwischen den Metallisierungsschichten 6 bzw. B6 und der Rückseitenmetallisierung 3 möglichst niederohmig zu realisieren, sollte eine möglichst hohe Dotierung > 10¹⁷/cm³ und eine möglichst geringe Germaniumdicke gewählt werden. Durch metallorganische Gasphasenepitaxie MOVPE oder Molekularstrahlepitaxie MBE wird nun eine Schichtstruktur abgeschieden. Die unterste abgeschiedene Schicht enthält Dotierstoffe, die durch Diffusion eine n-dotierte Germaniumschicht 17 erzeugen, so dass der pn-Übergang der Germanium-Solarzelle entsteht. Anschließend wird eine Tunneldiodenstruktur 18 abgeschieden, gefolgt von p-dotierten GaAs Schicht 19 und einer und einer n-dotierten GaAs-Schicht 20, die eine GaAs Solarzelle bilden. Nach einer weiteren Tunneldiode 21 wird eine GaInP Solarzelle bestehend aus einer p-dotierten Basis 22 und einem n-dotierten Emitter 23 abgeschieden. Eine GaAs Deckschicht 24 erlaubt die spätere Ausbildung eines niederohmigen Metall-Halbleiterkontakts zwischen der Deckschicht 24 und der Metallisierung 4. Die tatsächliche MOVPE gewachsene Schichtstruktur enthält noch weitere funktionelle Schichten zur Verbesserung des Wirkungsgrads der Solarzellen (z.B. Passivierungsschichten), die zum Verständnis hier jedoch unerheblich sind.

Es folgt die Prozessierung des Wafers 16-24 zu einer Solarzelle. Dazu werden durch Photolithographie und Ätzen die Schichten 17-24 bzw. 21-24 stellenweise entfernt. In einem weiteren Photolithographieschritt wird die Metallisierungsstruktur abgeschieden, die mindestens aus einer Palladiumschicht 25, einer darüberliegenden Germaniumschicht 26 und einer leitfähigen Schicht 27 (in der Regel Silber oder galvanisches Gold) besteht. Die Palladium-Germanium Schichtfolge hat die besondere Eigenschaft, sowohl auf den n-dotierten GaAs Schichten 20 und 24 als auch auf dem p-dotierten Germanium Substrat 16 ohmsche Kontakte mit sehr niedrigen Kontaktwiderständen auszubilden. Dies geschieht durch kontrollierte chemische Reaktionen in fester Phase beim Aufheizen der Halbleiterscheiben unter Schutzgas (Einlegieren der Kontakte). Auf diese Weise entsteht der Frontkontakt 4 der Solarzelle, der Frontkontakt B4 der Bypassdiode sowie die Kontakte 6 und B6 auf dem p-Germaniumsubstrat. Zur niederohmigen Kontaktierung durch das Germanium Substrat 16 hindurch wird noch ein niederohmiger Kontakt auf der Rückseite 3 benötigt. Dieser kann zum Beispiel aus einlegiertem Aluminium bestehen. Die weiteren Prozessschritte bei der Solarzellenherstellen wie das Mesa- Ätzen oder das Entfernen der Deckschicht 24 mit anschließendem aufdampfen einer Antireflexschicht sind dem Fachmann bekannt und sollen hier nicht eingehender erläutert werden.

Typischerweise erfolgt die Herstellung eines Konzentrator-Solarzellenmoduls in der folgenden Reihenfolge:
- Prozessierung von Halbleiterscheiben zu Solarzellen, wobei sich schließlich auf jeder Scheibe eine Vielzahl kleinerer Zellen befinden
- Zerteilung der Halbleiterscheiben in einzelne Zellen bzw. Solarzellenelemente
- Montage der Zellen auf einer Kühlfläche 9
- Serienverschaltung der Solarzellen

Bei Verwendung der erfindungsgemäßen Verschaltungsmethode kann jedoch eine Veränderung dieser Prozessreihenfolge vorteilhaft sein.
- Prozessierung der Halbleiterscheiben zu Solarzellen (mehrfaches Ausbilden der Elemente 1, 3, 4, 6 auf den Substraten 2, so dass nach späterer Auseinzelung mehrere Solarzellenelemente 8 entstehen).
- Optional: Zerteilung der Halbleiterscheiben in Stücke, wobei sich auf jedem Stück noch eine Vielzahl von Zellen befindet.
- Montage der ganzen Halbleiterscheiben oder der Halbleiterstücke auf einer Kühlfläche 9 durch einen Löt- oder Klebeprozess
- Zertrennen der Halbleiterscheiben oder Halbleiterstücke in einzelne Solarzellen.
- Serienverschaltung der Solarzellen

Zum Zertrennen des Halbleiters auf der Kühlfläche kann beispielsweise eine Chipsäge zum Einsatz kommen. Ihr sehr feines, diamantbesetztes Sägeblatt erlaubt Schnitte von 50 µm Breite und weniger. Damit sind Anordnungen gemäß den Zeichnungen 3 und 4 mit extrem geringem Abstand der Solarzellenchips 8 realisierbar. Alternativ kann beispielsweise Laserschneiden zum Einsatz kommen.

Für den Außeneinsatz insbesondere in Hohlspiegeln muss das Modul verkapselt werden. Dazu bietet sich eine mit Silikon montierte Frontglasplatte an. Dabei ist vor allem die sehr geringe Wärmeleitfähigkeit von Silikon limitierend und erfordert eine extrem dünne Silikonschicht. Bei 1000 Sonnen darf die Schichtdicke z.B. maximal 0,3 mm betragen um eine Überhitzung des Silikons zu vermeiden.

Dabei ist zu beachten, dass die Höhe der Zellverbinder 7 typischerweise mindestens 0,25 mm beträgt. Es ist somit eine Herausforderung die Schichtdicke des Silikons sehr genau zu kontrollieren. Wasserkühler weisen selten die dazu notwendigen geringen Toleranzen auf. Deshalb bietet sich die folgende Montagereihenfolge an.

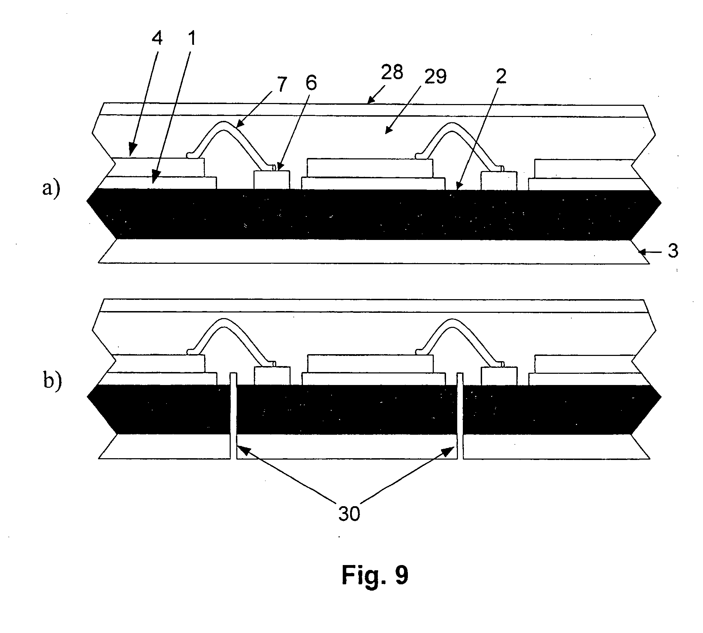

Gemäß Figur 9a) wird zunächst eine größere Halbleiterfläche, die mehrere Solarzellen umfasst, oder auch ein ganzer Solarzellenwafer mit mehreren Solarzellen zunächst mit Zellverbindern 7 versehen. Anschließend wird eine Frontscheibe 28 mit einer transparenten Vergussmasse 29 aufgebracht. Hier kann ein Vakuumverfahren verwendet werden um Luftblasen zu vermeiden. Die Einhaltung einer genau bestimmten Dicke der Silikonschicht 28 ist unproblematisch, da die Dicke des Solarzellenwafers und der Frontglasscheibe sehr wenig variiert. Nach Aushärten der Vergussmasse 29 werden Spalte 30 durch die Rückseitenmetallisierung 3 und das Halbleitermaterial 2 angebracht (Fig. 9b). Hiermit ist ein serienverschaltetes, frontseitig verkapseltes Modul hergestellt. Die Ankopplung der Rückseitenmetallisierung 3 an eine Kühlplatte muss so erfolgen, dass ein Kurzschluss der serienverschalteten Solarzellen ausgeschlossen ist.

Eine sehr präzise Methode zur Anfertigung der Spalte ist die Verwendung einer Chipsäge, womit eine Spaltbreite von bis hinunter zu 30 µm realisierbar ist. Weitere Möglichkeiten wären nass oder trockenchemisches Ätzen oder eine Kombination dieser Methoden.

Die vorliegende Erfindung beschreibt somit Solarzellenelemente bzw. Solarzellenmodule mit vorderseitig angebrachten Rückkontakten. Die Kontaktierung zeichnet sich insbesondere dadurch aus, dass mindestens eine vorderseitige metallische Kontaktfläche 6 ausschließlich durch die tragende Halbleiterschicht 2 bevorzugt genau eines Dotierungstyps von einer flächigen rückseitigen Kontaktfläche 3 getrennt ist. Entscheidend für hohe Stromdichten ist die gute Querleitfähigkeit der Rückseitenmetallisierung 3 und der geringe Widerstand beim Durchgang des Stroms durch die Halbleiterschicht 2. Eine solche gute Querleitfähigkeit kann durch eine hochleitfähige Metallschicht, typischerweise aus Al oder Ag, erreicht werden (typische Dicke dieser Schicht etwa 2 bis 3 µm). Insbesondere sind bei der vorliegenden Erfindung die folgenden Merkmale (welche einzeln oder auch in beliebiger Kombination in vorteilhaften Varianten realisiert werden können) von technischer Bedeutung:
- Die Palladium-Germanium Kontaktstruktur auf der Vorderseite (der tatsächliche Kontakt hat noch deutlich mehr Schichten) und der Aluminiumkontakt auf der Rückseite.
- Die Verwendung von mehreren oder genau einer Metallisierungsflächen 6 pro Solarzelle.
- Das Vereinzeln der Solarzellenchips nach der Montage durch Sägen oder Laserschneiden. Es lässt sich so eine fantastisch hohe Packungsdichte erzielen. Insbesondere auch die Montage eines (nahezu) vollständigen Solarzellenwafers mit anschließender Zerteilung und Serienverschaltung.
- Die Kühlplatte 9 kann ein strukturtragender Teil eines aktiven Wasserkühlkörpers sein. Beispielsweise stellt die Firma Electrovac (Curamik) Wasserkühlkörper her, die aus einer Mikrokanalstruktur zwischen zwei Keramikplatten bestehen. Die vordere Keramikplatte dient dabei gleichzeitig der Festigkeit des Kühlkörpers und als Grundplatte für eine Leiterstruktur.
- Eine Kontaktierung von der Metallschicht 6 zur Metallschicht 3 durch die Halbleiterschicht 2 mit einem flächenspezifischen Widerstand von weniger als 5*10⁻⁴ Ωcm². Experimentell erreicht wurden ca. 1*10⁻⁴ Ωcm². Der flächenspezifische Widerstand bestimmt sich hierbei aus:
   a) Dem Metall-Halbleiterkontaktwiderstand auf der Vorderseite und Rückseite der HalbleiterSubstratschicht 2.
   b) Der spezifischen Leitfähigkeit des Halbleitermaterials 2, welche wiederum proportional zur Dotierung und der Mobilität der Ladungsträger ist. Die Dotierung lässt sich hierbei in gewissen Grenzen wählen, bis bei sehr hoher Dotierung die Leistung der Germaniumzelle leidet. Die Mobilität bestimmt sich aus der Dotierung und der Materialqualität.
   c) Und der Dicke der Schicht 2 zwischen den Kontakten 3 und 6.
   Variabel sind hier die Dicke und Dotierung der Schicht 2. Es ist auch denkbar, jedoch technisch aufwändig, bis tief in die Halbleiterschicht 2 hineinzuätzen, um lokal den Abstand zwischen den Metallisierungen 3 und 6 zu verringern, um einen solchen flächenspezifischen Widerstand zu erreichen.
   - Ein alternativer Frontseitenkontakt (4,6), der zumindest Gold und Germanium enthält. (Eutektisches Gold-Germanium ist der bekannteste Kontakt auf n-Typ GaAs).
   - Solarzellen nach den obigen Ansprüchen, die für eine Lichtintensität von mindestens 100 kW/m² ausgelegt sind.
   - Die Zellfläche (Zellbreite) werde innerhalb des Moduls variiert, um eine inhomogene Beleuchtung des Solarmoduls auszugleichen.
   - Das Anbringen der Zellverbinder erfolgt durch Ultraschallschweißen (thermosonic bonding) von Gold, Aluminium oder Silberdraht im Ball-Wedge oder Wedge-Wedge Verfahren, alternativ durch E-lektroschweißen oder Löten.

Die vorliegende Erfindung eignet sich auch für Solarzellen, die unter nicht konzentriertem Sonnenlicht betrieben werden sollen. Insbesondere ist die Realisierung gemäß der Figuren 6 und 8 für Solarzellenmodule im Weltraumeinsatz interessant. Hier sind die Flächenanteile, die für die Kontakte 6 und B6 auszubilden sind, dann im Promillebereich. Wie auch beim Einsatz als Konzentratormodul erfolgt die Verschaltung der Solarzellen und Bypassdioden ausschließlich vorderseitig, was auch die Modulproduktion deutlich vereinfachen kann.

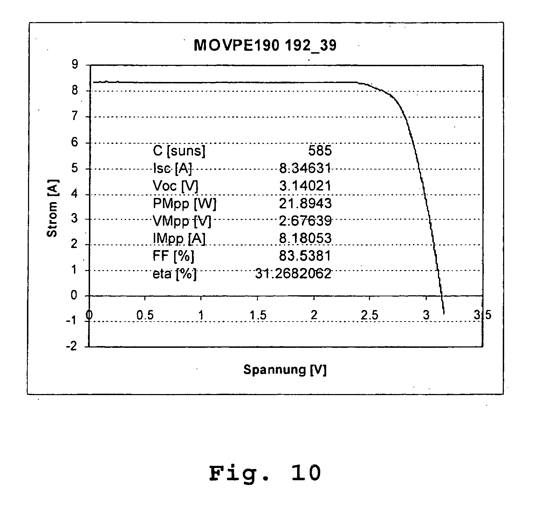

Figur 10 zeigt die Effizienz, welche mit einer Variante gemäß Figur 2b in einer nicht kalibrierten Messung erreicht wurde. Es konnte eine Effizienz von 31,3 % bei 585 Sonnen bei einer Zellfläche von etwa 20x6 mm² erreicht werden. Die Kontaktierung des Rückkontakts erfolgte hierbei über 32 Vorderseitenmetallflächen 6 und 32 Dünndrahtbonds. Es wurden Dreifachepitaxiestrukturen für den Weltraumeinsatz verwendet. Die Prozessierung entspricht weitestgehend der Prozessierung von III-V Weltraumsolarzellen.

## Patentansprüche

1. Solarzellenmodul umfassend
mindestens zwei in Serie geschaltete, jeweils mit einer Rückseitenmetallisierung (3a, 3b) auf einer Trägerstruktur (9, 10, 11) angeordnete Solarzellenelemente, wobei eine elektrische Kontaktierung mindestens zweier (8a, 8b) der serienverschalteten Solarzellenelemente ausschließlich auf einer der Trägerstruktur gegenüberliegenden Frontseite dieser Solarzellenelemente ausgebildet ist (Frontseitenverbindung),
wobei mindestens eines der mindestens zwei frontseitenverbundenen Solarzellenelemente aufweist:
eine tragende Halbleiterschicht (2) mit genau einem ersten Dotierungstyp (erste Dotierung),
eine auf einer Frontseite der tragenden Halbleiterschicht (2) angrenzend an die tragende Halbleiterschicht angeordnete Schichtstruktur (1), welche mindestens eine zu der ersten Dotierung komplementäre Dotierung aufweist,
die Rückseitenmetallisierung (3), wobei die Rückseitenmetallisierung (3) auf der der Schichtstruktur (1) gegenüberliegenden Rückseite der tragenden Halbleiterschicht (2) angrenzend an die tragende Halbleiterschicht angeordnet ist, und
eine erste (4) und eine zweite (6) Frontseitenmetallisierung, wobei die erste Frontseitenmetallisierung (4) die Schichtstruktur (1) elektrisch kontaktiert und wobei die zweite Frontseitenmetallisierung (6) räumlich beabstandet von der ersten Frontseitenmetallisierung und der Schichtstruktur (1) auf der Frontseite der tragenden Halbleiterschicht angrenzend an die tragende Halbleiterschicht so angeordnet ist, dass sich zwischen der zweiten Frontseitenmetallisierung (6) und der Rückseitenmetallisierung (3) ausschließlich die tragende Halbleiterschicht (2) befindet.

2. Solarzellenmodul nach dem vorhergehenden Anspruch,
**dadurch gekennzeichnet, dass**
die tragende Halbleiterschicht (2), die Rückseitenmetallisierung (3) und/oder die zweite Frontseitenmetallisierung (6) so angeordnet und/oder ausgebildet sind, dass die elektrische Kontaktierung von der Rückseitenmetallisierung (3) zur zweiten Frontseitenmetallisierung (6) durch die tragende Halbleiterschicht (2) eine flächenspezifischen Widerstand von kleiner 10⁻² Ωcm² vorzugsweise kleiner als 10⁻³ Ωcm², besonders bevorzugt kleiner als 5·10⁻⁴ Ωcm², aufweist.

3. Solarzellenmodul nach einem der vorhergehenden Ansprüche,
**dadurch gekennzeichnet, dass**
sich die Rückseitenmetallisierung (3) in Schichtebene gesehen von der zweiten Frontseitenmetallisierung (6) bis zur ersten Frontseitenmetallisierung (4) erstreckt und/oder dass die Rückseitenmetallisierung eine flächige, unstrukturierte oder eine strukturierte Metallisierung ist.

4. Solarzellenmodul nach einem der vorhergehenden Ansprüche,
***gekennzeichnet durch***
eine rückseitenmetallisierungsseitig angeordnete, eine Kühlplatte (9) oder eine Kühlplatte (9) mit nicht-metallischer oder keramischer Front, aufweisende Trägerstruktur (9, 10, 11).

5. Solarzellenmodul nach einem der vorhergehenden Ansprüche,
***dadurch gekennzeichnet, dass***
zu mindestens einem der Solarzellenelemente oder jedem Solarzellenelement eine Bypassdiode (13, 14, 15) mit umgekehrter Polarität parallel geschaltet ist.

6. Solarzellenmodul nach dem vorhergehenden Anspruch,
***dadurch gekennzeichnet, dass***
mindestens eines der Solarzellenelemente (8a, 8b) zusammen mit der Bypassdiode (14) einen gemeinsamen Abschnitt der tragenden Halbleiterschicht (2) aufweist.

7. Solarzellenmodul nach einem der beiden vorhergehenden Ansprüche,
***dadurch gekennzeichnet, dass***
mindestens eine der Bypassdioden (14, 15) auf ihrer trägerstruktur-abgewandten Frontseite eine erste (B4) und eine davon elektrisch isolierte zweite (B6) Frontseitenmetallisierung aufweist.

8. Solarzellenmodul nach einem der drei vorhergehenden Ansprüche,
***dadurch gekennzeichnet, dass***
mindestens eine der Bypassdioden (13, 14, 15) eine tragenden Halbleiterschicht (B2) mit einer ersten Dotierung, eine auf der trägerstruktur-abgewandten Frontseite der tragenden Halbleiterschicht angrenzend an die tragende Halbleiterschicht angeordnete Schichtstruktur (B1), welche mindestens eine zu der ersten Dotierung komplementäre Dotierung aufweist, und eine auf der der Schichtstruktur (B1) gegenüberliegenden Rückseite der tragenden Halbleiterschicht angrenzend an die tragende Halbleiterschicht angeordnete Rückseitenmetallisierung (B3) aufweist.

9. Solarzellenmodul nach den beiden vorhergehenden Ansprüche,
***dadurch gekennzeichnet, dass***
bei der mindestens einen Bypassdiode (14, 15) die erste Frontseitenmetallisierung (B4) die Schichtstruktur (B1) elektrisch kontaktiert und die zweite Frontseitenmetallisierung (B6) elektrisch isoliert von der ersten Frontseitenmetallisierung (B4) und der Schichtstruktur (B1) auf der Frontseite der tragenden Halbleiterschicht (B2) angrenzend an die tragende Halbleiterschicht (B2) angeordnet ist.

10. Solarzellenmodul nach einem der drei vorhergehenden Ansprüche,
***dadurch gekennzeichnet, dass***
mindestens eines der Solarzellenelemente auf der trägerstruktur-abgewandten Frontseite der tragenden Halbleiterschicht (2) und angrenzend an diese einen elektrisch von den Frontseitenmetallisierungen (4, 6) und der Schichtstruktur (1) isolierten metallischen Frontseitenkontakt (S6) aufweist, welcher mit der ersten Frontseitenmetallisierung (B4) der Bypassdiode (15) über einen Zellverbinder (SB7) elektrisch verbunden ist.

11. Solarzellenmodul nach einem der sechs vorhergehenden Ansprüche,
***dadurch gekennzeichnet, dass***
die elektrische Verschaltung der Solarzellenelemente (8) und der Bypassdioden (13, 14, 15) ausschließlich auf der trägerstruktur-abgewandten Frontseite ausgebildet ist.

12. Solarzellenmodul nach einem der vorhergehenden Ansprüche,
***dadurch gekennzeichnet, dass***
in der Schichtebene gesehen das Verhältnis des Flächenanteils der zweiten Frontseitenmetallisierung (6) und des Flächenanteils der Schichtstruktur (1) kleiner als 0,1, vorzugsweise kleiner als 0,05, besonders bevorzugt kleiner als 0,01, besonders bevorzugt kleiner als 0,005, besonders bevorzugt kleiner als 0,002 ist.

13. Verfahren zur Herstellung eines Solarzellenmoduls,
wobei mindestens zwei Solarzellenelemente jeweils mit ihrer Rückseitenmetallisierung (3a, 3b) auf einer Trägerstruktur (9, 10, 11) angeordnet und in Serie geschaltet werden, wobei die elektrische Kontaktierung mindestens zweier (8a, 8b) der serien- oder parallelverschalteten Solarzellenelemente ausschließlich auf einer der Trägerstruktur gegenüberliegenden Frontseite dieser Solarzellenelemente ausgebildet wird (Frontseitenverbindung) und wobei mindestens eines der Solarzellenelemente eine tragende Halbleiterschicht (2) mit genau einem ersten Dotierungstyp (erste Dotierung), eine auf der Frontseite der tragenden Halbleiterschicht (2) angrenzend an die tragende Halbleiterschicht angeordnete Schichtstruktur (1), welche mindestens eine zu der ersten Dotierung komplementäre Dotierung aufweist, eine auf der der Schichtstruktur (1) gegenüberliegenden Rückseite der tragenden Halbleiterschicht (2) angrenzend an die tragende Halbleiterschicht angeordnete Rückseitenmetallisierung (3), und eine erste (4) und eine zweite (6) Frontseitenmetallisierung, wobei die erste Frontseitenmetallisierung (4) die Schichtstruktur (1) elektrisch kontaktiert und wobei die zweite Frontseitenmetallisierung (6) räumlich beabstandet von der ersten Frontseitenmetallisierung und der Schichtstruktur (1) auf der Frontseite der tragenden Halbleiterschicht angrenzend an die tragende Halbleiterschicht so angeordnet ist, dass sich zwischen der zweiten Frontseitenmetallisierung (6) und der Rückseitenmetallisierung (3) ausschließlich die tragende Halbleiterschicht (2) als die elektrische Kontaktierung befindet, aufweist, indem auf einer tragenden Halbleiterschicht (2) alle Einzelelemente (1, 3, 4, 6) für ein Solarzellenelement (8) jeweils mehrfach ausgebildet werden,
indem danach die tragende Halbleiterschicht (2) samt der mehrfach ausgebildeten Einzelelemente (1, 3, 4, 6) auf der frontseiten-abgewandten Seite auf einer Trägerstruktur (9, 10) aufgeklebt und/oder aufgelötet wird (11),
indem danach die mehreren Solarzellenelemente (8) aus der auf die Trägerstruktur (9, 10) aufgebrachten tragenden Halbleiterschicht (2) ausgeeinzelt werden und
indem schließlich die einzelnen Solarzellenelemente (8) miteinander elektrisch verschaltet werden.

14. Verfahren zur Herstellung eines Solarzellenmoduls,
wobei mindestens zwei Solarzellenelemente jeweils mit ihrer Rückseitenmetallisierung (3a, 3b) auf einer Trägerstruktur (9, 10, 11) angeordnet und in Serie geschaltet werden, wobei der elektrische Kontakt mindestens zweier (8a, 8b) der serien- oder parallelverschalteten Solarzellenelemente ausschließlich auf der der Trägerstruktur gegenüberliegenden Frontseite dieser Solarzellenelemente ausgebildet wird (Frontseitenverbindung) und wobei mindestens eines der Solarzellenelemente eine eine elektrische Kontaktierung ausbildende, tragende Halbleiterschicht (2) mit genau einem ersten Dotierungstyp (erste Dotierung), eine auf der Frontseite der tragenden Halbleiterschicht (2) angrenzend an die tragende Halbleiterschicht angeordnete Schichtstruktur (1), welche mindestens eine zu der ersten Dotierung komplementäre Dotierung aufweist,
eine auf der der Schichtstruktur (1) gegenüberliegenden Rückseite der tragenden Halbleiterschicht (2) angrenzend an die tragende Halbleiterschicht angeordnete Rückseitenmetallisierung (3), und eine erste (4) und eine zweite (6) Frontseitenmetallisierung, wobei die erste Frontseitenmetallisierung (4) die Schichtstruktur (1) elektrisch kontaktiert und wobei die zweite Frontseitenmetallisierung (6) elektrisch isoliert von der ersten Frontseitenmetallisierung und der Schichtstruktur (1) auf der Frontseite der tragenden Halbleiterschicht angrenzend an die tragende Halbleiterschicht so angeordnet ist, dass sich zwischen der zweiten Frontseitenmetallisierung (6) und der Rückseitenmetallisierung (3) ausschließlich die tragende Halbleiterschicht (2) als die elektrische Kontaktierung befindet, aufweist,
indem auf einer tragenden Halbleiterschicht (2) alle Einzelelemente (1, 3, 4, 6) für ein Solarzellenelement (8) jeweils mehrfach ausgebildet werden,
indem danach die Frontseitenmetallisierung (4, 6) mindestens zweier unterschiedlicher, noch auszueinzelnder Solarzellenelemente (8) über Zellverbinder (7) elektrisch verschaltet wird, indem danach frontseitig eine transparente Vergussmasse und/oder Silikon aufgebracht wird,
indem danach auf der substratschicht-abgewandten Seite der Vergussmasse auf diese eine transparente Platte und/oder eine Glasplatte aufgebracht wird,
indem danach die mehreren Solarzellenelemente (8) aus der auf die Trägerstruktur (9, 10) aufgebrachten tragenden Halbleiterschicht (2) ausgeeinzelt werden, indem von der plattenabgewandten Seite zwischen den noch auszueinzelnden Solarzellenelementen (8) Spalte bis mindestens zur Vergussmasse eingetrieben werden und
indem schließlich die tragende Halbleiterschicht (2) samt der ausgeeinzelten Solarzellenelemente (8) auf ihrer frontseiten-abgewandten Seite auf einer Trägerstruktur (9, 10) aufgeklebt und/oder aufgelötet wird.

15. Verwendung eines Solarzellenmoduls nach einem der Ansprüche 1 bis 12 in einer Konzentratoranordnung.

## Claims

1. A solar cell module comprising
at least two solar cell elements connected in series and each having a rear-side metallisation (3a, 3b) and arranged on a carrier structure (9, 10, 11), wherein an electric contact of at least two (8a, 8b) of the solar cell elements connected in series is formed solely on a front side of the solar cell elements disposed opposite the carrier structure (front-side connection),
wherein at least one of the at least two solar cell elements connected at the front side has:
a carrying semiconductor layer (2) having exactly one first doping type (first doping);
a layer structure (1) which is arranged on a front side of the carrying semiconductor layer (2) adjacent to the carrying semi semiconductor layer and which has at least one doping complementary to the first doping;
the rear-side metallisation (3), wherein the rear-side metallisation (3) is arranged on the rear side of the carrying semiconductor layer (2) disposed opposite the layer structure (1) adjacent to the carrying semiconductor layer; and
a first (4) and a second (6) front-side metallisation, wherein the first front-side metallisation (4) electrically contacts the layer structure (1), and wherein the second front-side metallisation (6) is arranged spatially spaced apart from the first front-side metallisation and the layer structure (1) on the front side of the carrying semiconductor layer adjacent to the carrying semiconductor layer such that only the carrying semiconductor layer (2) is located between the second front-side metallisation (6) and the rear-side metallisation (3).

2. A solar cell module in accordance with the preceding claim,
**characterised in that**
the carrying semiconductor layer (2), the rear-side metallisation (3) and/or the second front-side metallisation (6) are arranged and/or configured such that the electrical contact from the rear-side metallisation (3) to the second front-side metallisation (6) through the carrying semiconductor layer (2) has a surface-specific resistance of smaller than 10⁻² Ωcm², preferably smaller than 10⁻³ Ωcm², particularly preferably smaller than 5·10⁻⁴ Ωcm².

3. A solar cell module in accordance with one of the preceding claims,
**characterised in that**
the rear-side metallisation (3) extends, viewed in the layer plane, from the second front-side metallization (6) up to the first front-side metallisation (4); and/or **in that** the rear-side metallisation is an areal, unstructured metallisation or a structured metallisation.

4. A solar cell module in accordance with one of the preceding claims,
**characterised by**
a carrier structure (9, 10, 11) arranged at a rear-side metallisation side and having a cooling plate (9) or a cooling plate (9) with a non-metallic or ceramic front.

5. A solar cell module in accordance with one of the preceding claims,
**characterised in that**
a bypass diode (13, 14, 15) having reversed polarity is connected in parallel with at least one of the solar cell elements or with each solar cell element.

6. A solar cell module in accordance with the preceding claim,
**characterised in that**
at least one of the solar cell elements (8a, 8b), together with the bypass diode (14), has a common section of the carrying semiconductor layer (2).

7. A solar cell module in accordance with one of the two preceding claims,
**characterised in that**
at least one of the bypass diodes (14, 15) has a first (B4) and a second (B6) front-side metallisation electrically insulated from the first on its front side remote from the carrier structure.

8. A solar cell module in accordance with one of the three preceding claims,
**characterised in that**
at least one of the bypass diodes (13, 14, 15) has a carrying semiconductor layer (B2) having a first doping, a layer structure (B1) which is arranged on the front side of the carrying semiconductor layer remote from the carrier structure adjacent to the carrying semiconductor layer and which has at least one doping complementary to the first doping, and has a rear-side metallisation (B3) arranged on the rear side of the carrying semiconductor layer disposed opposite the layer structure (B1) adjacent to the carrying semiconductor layer.

9. A solar cell module in accordance with the two preceding claims,
**characterised in that**
in the at least one bypass diode (14, 15), the first front-side metallisation (B4) electrically contacts the layer structure (B1) and the second front-side metallisation (B6) is arranged electrically insulated from the first front-side metallisation (B4) and from the layer structure (B1) on the front side of the carrying semiconductor layer (B2) adjacent to the carrying semiconductor layer (B2).

10. A solar cell module in accordance with one of the three preceding claims,
**characterised in that**
at least one of the solar cell elements has a metallic front-side contact (S6) on the front side of the carrying semiconductor layer (2) remote from the carrier structure and adjacent to said carrying semiconductor layer and electrically insulated from the front-side metallisations (4, 6) and the layer structure (1), said front-side contact being electrically connected to the first front-side metallisation (B4) of the bypass diode (15) via a cell connector (SB7).

11. A solar cell module in accordance with one of the six preceding claims,
**characterised in that**
the electrical connection of the solar cell elements (8) and of the bypass diodes (13, 14, 15) is only formed on the front side remote from the carrier structure.

12. A solar cell module in accordance with one of the preceding claims,
**characterised in that**
the ratio of the surface portion of the second front-side metallisation (6) and of the surface portion of the layer structure (1), viewed in the layer plane, is smaller than 0.1, preferably smaller than 0.05, particularly preferably smaller than 0.01, particularly preferably smaller than 0.005, particularly preferably smaller than 0.002.

13. A method of manufacturing a solar cell module, wherein the respective rear-side metallisation (3a, 3b) of at least two solar cell elements are arranged on a carrier structure (9, 10, 11) and are connected in series, wherein the electric contact of at least two (8a, 8b) of the solar cell elements connected in series or in parallel is formed solely on a front side of these solar cell elements disposed opposite the carrier structure (front-side connection); and wherein at least one of the solar cell elements has a carrying semiconductor layer (2) having exactly one first doping type (first doping), a layer structure (1) which is arranged on the front side of the carrying semiconductor layer (2) adjacent to the carrying semiconductor layer and which has at least one doping complementary to the first doping; a rear-side metallisation (3) arranged on the rear side of the carrying semiconductor layer (2) disposed opposite the layer structure (1) and a first (4) and a second (6) front-side metallisation, wherein the first front-side metallisation (4) electrically contacts the layer structure (1); and wherein the second front-side metallization (6) is arranged spatially spaced apart from the first front-side metallisation and from the layer structure (1) on the front side of the carrying semiconductor layer adjacent to the carrying semiconductor layer such that only the carrying semiconductor layer (2) as the electrical contact is located between the second front-side metallisation (6) and the rear-side metallisation (3) in that all the individual elements (1, 3, 4, 6) for a solar cell element (8) are each formed in multiple form on a carrying semiconductor layer (2),
in that afterwards the carrying semiconductor layer (2), together with the individual elements (1, 3, 4, 6) formed in multiple forms, is adhesively bonded and/or soldered (11) on a carrier structure (9, 10) on the side remote from the front side,
in that afterwards the plurality of solar cell elements (8) are individualised from the carrying semiconductor layer (2) applied to the carrier structure (9, 10), and
in that finally the individual solar cell elements (8) are electrically connected to one another.

14. A method of manufacturing a solar cell module,
wherein the respective rear-side metallisations (3a, 3b) of at least two solar cell elements are arranged on a carrier structure (9, 10, 11) and are connected in series, wherein the electrical contact of at least two (8a, 8b) of the solar cell elements connected in series or in parallel is formed exclusively on the front side of these solar cell elements disposed opposite the carrier structure (front-side connection), and wherein at least one of the solar cell elements has a carrying semiconductor layer (2) forming an electric contact and having exactly one doping type (first doping), a layer structure (1) which is arranged on the front side of the carrying semiconductor layer (2) adjacent to the carrying semiconductor layer and which has at least one doping complementary to the first doping,
a rear-side metallisation (3) arranged on the rear side of the carrying semiconductor layer (2) disposed opposite the layer structure (1) adjacent to the carrying semiconductor layer and a first (4) and a second (6) front-side metallisation, wherein the first front-side metallisation (4) electrically contacts the layer structure (1), and wherein the second front-side metallisation (6) is arranged electrically insulated from the first front-side metallisation and from the layer structure (1) on the front side of the carrying semiconductor layer adjacent to the carrying semiconductor layer such that only the carrying semiconductor layer (2) is located as the electrical contact between the second front-side metallisation (6) and the rear-side metallisation (3),
in that all the individual elements (1, 3, 4, 6) for a solar cell element (8) are each formed in multiple forms on a carrying semiconductor layer (2),
in that afterwards the front-side metallisation (4, 6) of at least two different solar cell elements (8) to be individualised is electrically connected via cell connectors (7) in that afterwards a transparent moulding compound and/or silicone is/are applied at the front side,
in that afterwards a transparent plate and/or a glass plate is/are applied to the side of the moulding compound remote from the substrate layer,
in that afterwards the plurality of solar cell elements (8) are individualised from the carrying semiconductor layer (2) applied to the carrier structure (9, 10) in that gaps are driven in from the side remote from the plate between the solar cell elements (8) still to be individualised up to at least the moulding compound, and
in that finally the carrying semiconductor layer (2), together with the individualised solar cell elements (8), is adhesively bonded and/or soldered to a carrier structure (9, 10) on its side remote from the front side.

15. Use of a solar cell module in accordance with one of the claims 1 to 12 in a concentrator arrangement.

## Revendications

1. Module de cellule solaire comprenant
au moins deux éléments de cellule solaire montés en série, agencés respectivement avec une métallisation du côté arrière (3a, 3b) sur une structure portante (9, 10, 11), un contact électrique d'au moins deux (8a, 8b) des éléments de cellule solaire montés en série étant formé exclusivement sur un côté avant de ces éléments de cellule solaire opposé à la structure portante (raccordement du côté avant),
au moins un des au moins deux éléments de cellule solaire raccordés du côté avant présentant :
une couche semi-conductrice porteuse (2) avec précisément un premier type de dopage (premier dopage),
une structure de couche (1) agencée sur un côté avant de la couche semi-conductrice porteuse (2) de manière adjacente à la couche semi-conductrice porteuse, qui présente au moins un dopage complémentaire au premier dopage,
la métallisation du côté arrière (3), la métallisation du côté arrière (3) étant agencée sur le côté arrière de la couche semi-conductrice porteuse (2) opposé à la structure de couche (1) de manière adjacente à la couche semi-conductrice porteuse, et
une première (4) et une deuxième (6) métallisation du côté avant, la première métallisation du côté avant (4) étant en contact électrique avec la structure de couche (1) et la deuxième métallisation du côté avant (6) étant agencée à distance spatialement de la première métallisation du côté avant et de la structure de couche (1) sur le côté avant de la couche semi-conductrice porteuse, de manière adjacente à la couche semi-conductrice porteuse, de telle sorte qu'entre la deuxième métallisation du côté avant (6) et la métallisation du côté arrière (3) se trouve exclusivement la couche semi-conductrice porteuse (2).

2. Module de cellule solaire selon la revendication précédente,
**caractérisé en ce que**
la couche semi-conductrice porteuse (2), la métallisation du côté arrière (3) et/ou la deuxième métallisation du côté avant (6) sont agencées et/ou formées de telle sorte que le contact électrique de la métallisation du côté arrière (3) avec la deuxième métallisation du côté avant (6) réalisé par la couche semi-conductrice porteuse (2) présente une résistance spécifique à la surface inférieure à 10⁻²Ωcm², de préférence inférieure à 10⁻³Ωcm² et de manière particulièrement préférée inférieure à 5.10⁻⁴ Ωcm².

3. Module de cellule solaire selon l'une quelconque des revendications précédentes,
**caractérisé en ce que**
la métallisation du côté arrière (3), vu dans le plan de la couche, s'étend de la deuxième métallisation du côté avant (6) jusqu'à la première métallisation du côté avant (4) et/ou **en ce que** la métallisation du côté arrière est une métallisation plane, non structurée ou structurée.

4. Module de cellule solaire selon l'une quelconque des revendications précédentes,
**caractérisé**
**par** une structure portante (9, 10, 11) agencée du côté de la métallisation du côté arrière présentant une plaque refroidissante (9) ou une plaque refroidissante (9) dotée d'une face non métallique ou céramique.

5. Module de cellule solaire selon l'une quelconque des revendications précédentes,
**caractérisé en ce**
**qu'**une diode de dérivation (13, 14, 15) de polarité inversée est montée en parallèle à au moins un des éléments de cellule solaire ou à chaque élément de cellule solaire.

6. Module de cellule solaire selon la revendication précédente,
**caractérisé en ce**
**qu'**au moins un des éléments de cellule solaire (8a, 8b) présente, conjointement avec la diode de dérivation (14), une section commune de la couche semi-conductrice porteuse (2).

7. Module de cellule solaire selon l'une quelconque des deux revendications précédentes,
**caractérisé en ce**
**qu'**au moins une des diodes de dérivation (14, 15) présente, sur son côté avant opposé à la structure portante, une première (B4) et une deuxième (B6) métallisation du côté avant isolée électriquement de la précédente.

8. Module de cellule solaire selon l'une quelconque des trois revendications précédentes,
**caractérisé en ce**
**qu'**au moins une des diodes de dérivation (13, 14, 15) présente une couche semi-conductrice porteuse (B2) dotée d'un premier dopage, une structure de couche (B1) agencée sur le côté avant de la couche semi-conductrice porteuse opposé à la structure portante de manière adjacente à la couche semi-conductrice porteuse, qui présente au moins un dopage complémentaire au premier dopage, et une métallisation du côté arrière (B3) agencée sur le côté arrière de la couche semi-conductrice porteuse opposé à la structure de couche (B1) de manière adjacente à la couche semi-conductrice porteuse.

9. Module de cellule solaire selon les deux revendications précédentes,
**caractérisé en ce**
**que** pour l'au moins une diode de dérivation (14, 15), la première métallisation du côté avant (B4) est en contact électrique avec la structure de couche (B1) et la deuxième métallisation du côté avant (B6) est agencée de manière à être isolée électriquement de la première métallisation du côté avant (B4) et de la structure de couche (B1) sur le côté avant de la couche semi-conductrice porteuse (B2) de manière adjacente à la couche semi-conductrice porteuse (B2).

10. Module de cellule solaire selon l'une quelconque des trois revendications précédentes,
**caractérisé en ce**
**qu'**au moins un des éléments de cellule solaire présente, sur le côté avant opposé à la structure portante de la couche semi-conductrice porteuse (2) et de manière adjacente à celle-ci, un contact métallique du côté avant (S6) isolé électriquement des métallisations du côté avant (4, 6) et de la structure de couche (1), qui est relié électriquement à la première métallisation du côté avant (B4) de la diode de dérivation (15) par le biais d'un connecteur de cellule (SB7).

11. Module de cellule solaire selon l'une quelconque des six revendications précédentes,
**caractérisé en ce**
**que** la commutation électrique des éléments de cellule solaire (8) et des diodes de dérivation (13, 14, 15) est formée exclusivement sur le côté avant opposé à la structure portante.

12. Module de cellule solaire selon l'une quelconque des revendications précédentes,
**caractérisé en ce**
**que** vu dans le plan de la couche, le rapport entre la part de la surface de la deuxième métallisation du côté avant (6) et la part de la surface de la structure de couche (1) est inférieur à 0,1, de préférence inférieur à 0,05, de manière particulièrement préférée inférieur à 0,01, de manière particulièrement préférée inférieur à 0,005 et de manière particulièrement préférée inférieur à 0,002.

13. Procédé de fabrication d'un module de cellule solaire,
au moins deux éléments de cellule solaire étant respectivement agencés et montés en série avec leur métallisation du côté arrière (3a, 3b) sur une structure portante (9, 10, 11), le contact électrique d'au moins deux (8a, 8b) des éléments de cellule solaire montés en série ou en parallèle étant formé exclusivement sur un côté avant de ces éléments de cellule solaire opposé à la structure portante (raccordement du côté avant) et au moins un des éléments de cellule solaire présentant une couche semi-conductrice porteuse (2) avec précisément un premier type de dopage (premier dopage), une structure de couche (1) agencée sur un côté avant de la couche semi-conductrice porteuse (2) de manière adjacente à la couche semi-conductrice porteuse, qui présente au moins un dopage complémentaire au premier dopage, une métallisation du côté arrière (3) agencée sur le côté arrière de la couche semi-conductrice porteuse (2) opposé à la structure de couche (1) de manière adjacente à la couche semi-conductrice porteuse, et une première (4) et une deuxième (6) métallisation du côté avant, la première métallisation du côté avant (4) étant en contact électrique avec la structure de couche (1) et la deuxième métallisation du côté avant (6) étant agencée à distance spatialement de la première métallisation du côté avant et de la structure de couche (1) sur le côté avant de la couche semi-conductrice porteuse, de manière adjacente à la couche semi-conductrice porteuse, de telle sorte qu'entre la deuxième métallisation du côté avant (6) et la métallisation du côté arrière (3) se trouve exclusivement la couche semi-conductrice porteuse (2) en tant que contact électrique, en ce que tous les éléments individuels (1, 3, 4, 6) destinés à un élément de cellule solaire (8) sont formés respectivement plusieurs fois sur une couche semi-conductrice porteuse (2),
en ce que la couche semi-conductrice porteuse (2), y compris les éléments individuels (1, 3, 4, 6) formés plusieurs fois sur le côté opposé au côté avant, est ensuite collée et/ou soudée (11) sur une structure portante (9, 10),
en ce que plusieurs éléments de cellule solaire (8) sont ensuite séparés individuellement à partir de la couche semi-conductrice porteuse (2) appliquée sur la structure portante (9, 10), et en ce que les éléments de cellule solaire (8) individuels sont finalement raccordés électriquement les uns avec les autres.

14. Procédé de fabrication d'un module de cellule solaire,
au moins deux éléments de cellule solaire sont respectivement agencés et montés en série avec leur métallisation du côté arrière (3a, 3b) sur une structure portante (9, 10, 11), le contact électrique d'au moins deux (8a, 8b) des éléments de cellule solaire montés en série ou en parallèle étant formé exclusivement sur le côté avant de ces éléments de cellule solaire opposé à la structure portante (raccordement du côté avant) et au moins un des éléments de cellule solaire présentant une couche semi-conductrice porteuse (2) formant un contact électrique avec précisément un premier type de dopage (premier dopage), une structure de couche (1) agencée sur le côté avant de la couche semi-conductrice porteuse (2) de manière adjacente à la couche semi-conductrice porteuse, qui présente au moins un dopage complémentaire au premier dopage,
une métallisation du côté arrière (3) agencée sur le côté arrière de la couche semi-conductrice porteuse (2) opposé à la structure de couche (1) de manière adjacente à la couche semi-conductrice porteuse, et une première (4) et une deuxième (6) métallisation du côté avant, la première métallisation du côté avant (4) étant en contact électrique avec la structure de couche (1) et la deuxième métallisation du côté avant (6) étant agencée de manière à être isolée électriquement de la première métallisation du côté avant et de la structure de couche (1) sur le côté avant de la couche semi-conductrice porteuse, de manière adjacente à la couche semi-conductrice porteuse, de telle sorte qu'entre la deuxième métallisation du côté avant (6) et la métallisation du côté arrière (3) se trouve exclusivement la couche semi-conductrice porteuse (2) en tant que contact électrique,
en ce que tous les éléments individuels (1, 3, 4, 6) destinés à un élément de cellule solaire (8) sont formés respectivement plusieurs fois sur une couche semi-conductrice porteuse (2),
en ce que la métallisation du côté avant (4, 6) d'au moins deux éléments de cellule solaire (8) différents devant encore être séparés est ensuite raccordée électriquement par le biais de connecteurs de cellule (7),
en ce qu'une masse de scellement transparente et/ou du silicone est ensuite appliqué sur le côté avant,
en ce qu'une plaque transparente et/ou une plaque de verre est ensuite appliquée sur le côté opposé à la couche de substrat de la masse de scellement,
en ce que plusieurs éléments de cellule solaire (8) sont ensuite séparés individuellement à partir de la couche semi-conductrice porteuse (2) appliquée sur la structure portante (9, 10) en ce que des fentes sont dessinées entre les éléments de cellule solaire (8) devant encore être séparés depuis le côté opposé à la plaque au moins jusqu'à la masse de scellement, et
en ce que la couche semi-conductrice porteuse (2), y compris les éléments de cellule solaire (8) séparés sur son côté opposé au côté avant, est finalement collée et/ou soudée sur une structure portante (9, 10).

15. Utilisation d'un module de cellule solaire selon l'une quelconque des revendications 1 à 12 dans un agencement de concentrateur.
